(19) Europäisches Patentamt
European Patent Office
Office européen des brevets

(11) **EP 1 600 946 B1**

(12) **EUROPEAN PATENT SPECIFICATION**

(45) Date of publication and mention
of the grant of the patent:
**18.11.2009 Bulletin 2009/47**

(51) Int Cl.:
**G10L 19/02** (2006.01)

(21) Application number: **05253245.4**

(22) Date of filing: **26.05.2005**

(54) **Method and apparatus for encoding a digital audio signal**

Verfahren und Vorrichtung zur Kodierung eines digitalen Audiosignals

Procédé et dispositif pour le codage d'un signal audio numérique

(84) Designated Contracting States:
**DE FI FR GB NL SE**

(30) Priority: **28.05.2004 KR 2004038212**

(43) Date of publication of application:
**30.11.2005 Bulletin 2005/48**

(60) Divisional application:
**08164671.3 / 1 998 321**

(73) Proprietor: **SAMSUNG ELECTRONICS CO., LTD.
Suwon-si,
Gyeonggi-do (KR)**

(72) Inventors:
• **Kim, Dohyung
306-303 Sinyeongtong Hyundai Apt.
Hwaseong-si
Gyeonggi-do (KR)**
• **Lee, Shihwa
Seocho-gu
Seoul (KR)**
• **Kim, Junghoe
Gangseo-gu
Seoul (KR)**
• **Kim, Sangwook
Gangnam-gu
Seoul (KR)**
• **Seo, Yangseock
504-603 Suji Samsung 5-cha Apt.
Yongin-si
Gyeonggi-do (KR)**

(74) Representative: **Greene, Simon Kenneth
Elkington and Fife LLP
Prospect House
8 Pembroke Road
Sevenoaks
Kent TN13 1XR (GB)**

(56) References cited:
**EP-A1- 1 596 366    US-A- 5 864 802**

• **XP000978167**

**Description**

Embodiments of the present invention relate to encoding and decoding of a digital signal, and more particularly, to a method and apparatus for encoding/decoding a digital signal, in which a digital signal is encoded into a bit stream including information about a length of a frame by using a plurality of lookup tables and linear quantization by sections, and the bit stream is decoded into the original digital signal.

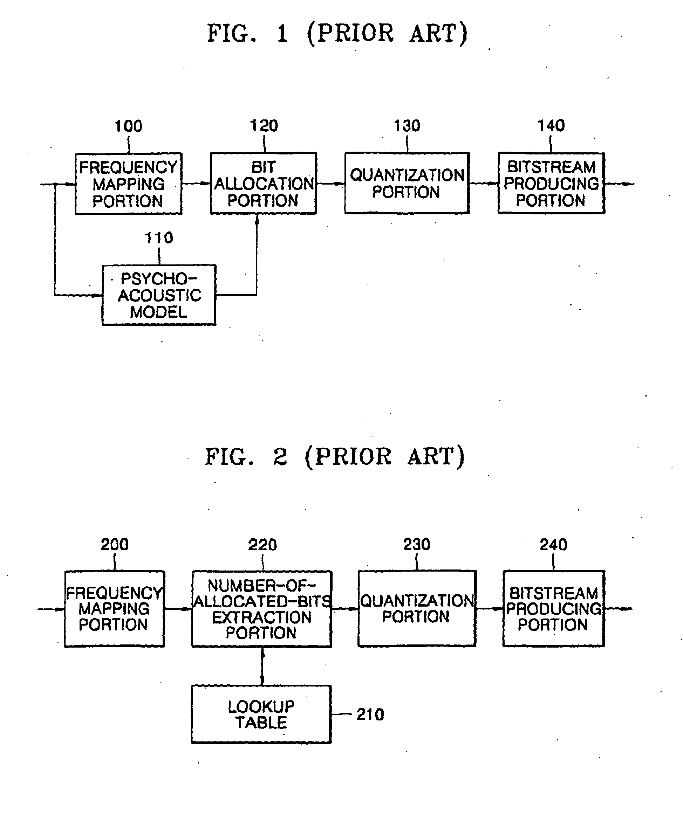

FIG. 1 is a block diagram of a general digital signal encoding apparatus using an acoustic psychology model in the MPEG-1. The general digital signal encoding apparatus is comprised of a frequency mapping portion 100, an acoustic psychology (psycho-acoustic) model 110, a bit allocation portion 120, a quantization portion 130, and a bitstream producing portion 140.

The frequency mapping portion 100 transforms a time-domain input signal into a predetermined number of frequency bands using a band analysis filter. The acoustic psychology model 110 is a portion of the encoding apparatus that performs the most complicate calculation. That is, the acoustic psychology model 110 calculates a signal-to-mask ratio (SMR), which is a basis of bit allocation for each frequency band. The SMR is calculated by the following operations. First, a time-domain audio signal is transformed into a frequency-domain audio signal using fast Fourier transform (FFT), and a sound pressure level and an absolute threshold of each frequency band are calculated. Thereafter, voice and voiceless sound components of the audio signal and a masker of the audio signal are determined, and a masking threshold of each frequency band and an overall masking threshold are calculated. Finally, a minimal masking threshold of each frequency band is calculated, thereby calculating the SMR of each frequency band.

The bit allocation portion 120 calculates the number of bits to be allocated for each frequency band by repeating the following operations based on the SMR received from the acoustic psychology model 110. First, an initial allocated bit is set as 0, and a mask-to-noise ratio (MNR) for each frequency band is obtained. Here, the MNR is obtained by subtracting the SMR from a signal-to-noise ratio (SNR). Thereafter, a frequency band having the minimal MNR among MNRs for the frequency bands is searched for, and the number of bits allocated for the found frequency band increases 1. If the number of bits allocated for the entire input signal does not exceed a required number of allocated bits, frequency bands other than the found frequency band undergo the above-described operations.

The quantization portion 130 quantizes the input signal using a scale vector and allocated bits. The bitstream producing portion 140 produces a bit stream using the quantized input signal.

As described above, a conventional digital signal encoding method using an acoustic psychology model obtains an SMR through a complicated process. Thus, a calculation performed in the conventional digital signal encoding method becomes complicated, leading to an increase in the time required to execute the digital signal encoding method. Since an MNR is calculated using the SMR obtained through the complicate process, and a bit allocation loop is repeated based on the MNR, time delay also occurs during the repetition of the bit allocation loop.

FIG. 2 is a block diagram of a conventional digital signal encoding apparatus using a single lookup table. The encoding apparatus is comprised of a frequency mapping portion 200, a lookup table 210, a number-of-allocated-bits extraction portion 220, a quantization portion 230, and a bitstream producing portion 240.

The frequency mapping portion 200 transforms a time-domain input signal into a predetermined number of frequency bands using a band analysis filter. The lookup table 210 stores numbers of bits allocated to encode the frequency bands, in addresses corresponding to characteristics of the frequency bands.

The number-of-allocated-bits extraction portion 220 calculates an address value for each of the frequency bands of the input signal and extracts the numbers of allocated bits stored in the addresses for the frequency bands from the lookup table 210. The quantization portion 230 quantizes the input signal using the numbers of bits allocated for the frequency bands. The bitstream producing portion 240 produces a bitstream using the quantized input signal.

In a conventional method of encoding a digital signal using a single lookup table, to obtain a number of bits allocated for a unit in which the digital signal is quantized (hereafter, referred to as a quantization unit) as described above, the numbers of bits allocated per frequency band are extracted from the lookup table and used in encoding the digital signal. Hence, the complicated calculation and the time delay due to the use of an acoustic psychology model can be prevented. However, since various input signals having different characteristics must be encoded using the single lookup table, there exists a limit in adaptively encoding the input signals according to their characteristics.

In the MPEG-1/2 audio encoding technology, sub-band samples obtained by sub-band filtering are linearly quantized using information about bit allocation presented by psychoacoustics and undergo a bit packing process, thereby completing audio encoding. A linear quantizer, which performs the linear quantization, provides optimal performance when data has a uniform distribution. However, a data distribution is actually approximate to a Guassian or Laplacian distribution. Hence, the quantizer is preferably designed to fit each distribution, and can show an optimal result in respect of a mean squared error (MSE). A general audio encoder, such as, an MPEG-2/4 Advanced Audio Coding (AAC) encoder, uses a $x^{4/3}$ nonlinear quantizer, which is designed in consideration of a sample distribution of a modified discrete cosine transform (MDCT) and the psycho-acoustic perspective. However, the encoder is highly complex due to the characteristics of a nonlinear quantizer. Therefore, the nonlinear quantizer cannot be used as an audio encoder that requires low complexity.

When audio encoding proposed by MPEG-1 and MPEG-2 is performed using a fixed bitrate, sync information is located at a beginning portion of each frame. When audio encoding proposed by MPEG-4 is not performed at a fixed bitrate, information about a frame length is located at a beginning portion of each frame.

When an impact is applied to an audio reproducing apparatus, only effective data, which is not affected by the impact, except for an impacted portion of a buffer in the audio reproducing apparatus should be reproduced. When an encoding rate used is a fixed bit rate, a length of each frame, that is, a size of an area of the buffer occupied by each frame, is consistent. Accordingly, an area of the buffer occupied by a frame previous to a damaged frame can be easily searched for. On the other hand, when the encoding rate used is a variable bit rate, a length of each frame, that is, a size of an area of the buffer occupied by each frame, is inconsistent. Accordingly, it is impossible to search for an area of the buffer occupied by a frame previous to a damaged frame by only using frame length information recorded at a beginning portion of each frame.

US5,864,802 describes an audio encoding method using a single look-up table.

EP15 96366, which has an earlier priority date to the present case but was published after the filing date, describes an audio encoding method with a plurality of look-up tables.

According to an aspect of the present invention, there is provided a method of encoding a digital signal according to claim 1.

The transformation of the digital signal may be performed using one of a modified discrete cosine transform, a fast Fourier transform, a discrete cosine transform, and a sub-band filtering. The side information may include at least a scale factor of each quantization unit and a number of bits to be allocated for each quantization unit.

The characteristic of the input signal in the operation of selecting the lookup table and acquiring the number of bits allocated may be the number of frequency bands including samples at occupancy rates no less than or no greater than a predetermined reference value among frequency bands of the input signal. The occupancy rate may comprise either or both of a larger occupancy rate between an occupancy rate of a squared scale factor of a frequency band and an occupancy rate of a mean power of samples within the frequency band or a larger occupancy rate between an occupancy rate of a scale factor of a frequency band and an occupancy rate of a mean value of samples within the frequency band.

Each of the lookup tables may include at least one address for each quantization unit and a predetermined number of bits for each quantization unit. The addresses of each of the lookup tables may comprise scale factors or squared scale factors of the frequency bands, mean values or mean powers of samples within the frequency bands, larger occupancy rates between occupancy rates of scale factors of the frequency bands and occupancy rates of mean values of samples within the frequency bands, or larger occupancy rates between occupancy rates of squared scale factors of the frequency bands and occupancy rates of mean powers of samples within the frequency bands.

The operation of dividing the distribution of the samples and linearly quantizing the samples may include: normalizing the samples within each quantization unit using a predetermined scale factor; dividing a range of normalized sample values into a predetermined number of sections and transforming the normalized sample values by applying a linear function set for each section; scaling the transformed values using the number of bits allocated for each quantization unit; and rounding the scaled values to the nearest whole number to obtain quantized values.

The scale factor may be an integer determined by a predetermined function of a value no less than a maximum absolute value among sample values within each quantizing unit.

The linear functions may be a plurality of independent linear functions for the sections. The operation of dividing the range of the normalized sample values and transforming the normalized sample values may comprise: dividing the range of the normalized sample values into two sections; and transforming the normalized data by applying linear functions set for the two sections to the normalized data. The linear functions are expressed as $y \approx \dfrac{ax}{(a-2b)}$ and

$y = \dfrac{x}{(1+2b)} + \dfrac{2b}{(1+2b)}$, wherein a denotes the range of normalized values, and *b* denotes section displacement from the center of a. The linear quantizàtion by sections may satisfy continuity.

The bitstream comprised of frames may further include sync information indicating a beginning of each frame, which is located in a head portion of each frame. The bitstream comprised of frames may be a result of encoding at a fixed bit rate or a variable bit rate.

According to another aspect of the present invention, there is provided an apparatus for encoding a digital signal according to claim 22.

The characteristic of the input signal in the selecting of the lookup table and acquiring of the number of bits allocated may comprise the number of frequency bands including samples at occupancy rates no less than or no greater than a predetermined reference value among frequency bands of the input signal. The occupancy rate may comprise either or both of a larger occupancy rate between an occupancy rate of a squared scale factor of a frequency band and an occupancy rate of a mean power of samples within the frequency band or a larger occupancy rate between an occupancy rate of a scale factor of a frequency band and an occupancy rate of a mean value of samples within the frequency band.

The linear quantization portion may comprise a data normalization portion normalizing the samples obtained by the data transformation portion using a predetermined scale factor, a section quantization portion dividing a range of normalized sample values into a predetermined number of sections and applying a linear function set for each section to the normalized sample values, a scaling portion scaling the values obtained by the section quantization portion using the number of bits allocated for each quantization unit by the bit allocation portion, and a rounding portion rounding the scaled values to the nearest whole number using the number of allocated bits to obtain quantized values.

The bitstream comprised of frames may further include sync information indicating a beginning of each frame, which is located in a head portion of each frame.

An embodiment of the present invention provides a method and an apparatus for encoding a digital signal, by which the digital signal is adaptively encoded using a plurality of lookup tables produced based on characteristics of the digital signal, and the complexity of a nonlinear quantizer is significantly reduced while providing a sound of better quality than a general linear quantizer in consideration of a distribution of digital data.

An embodiment of the present invention also provides a method and an apparatus for encoding a digital signal, by which the digital signal is adaptively encoded using a plurality of lookup tables produced based on characteristics of the digital signal to produce a bitstream including frame length information useful upon digital signal encoding at a variable bitrate.

An embodiment of the present invention also provides a method and an apparatus for encoding a digital signal, by which the complexity of a nonlinear quantizer is significantly reduced while providing a sound of better quality than a general linear quantizer in consideration of a distribution of digital data, and the digital signal is encoded into a bitstream including frame length information useful upon digital signal encoding at a variable bitrate.

An embodiment of the present invention also provides a method and an apparatus for encoding a digital signal, by which the digital signal is adaptively encoded using a plurality of lookup tables produced based on characteristics of the digital signal, the complexity of a nonlinear quantizer is significantly reduced while providing a sound of better quality than a general linear quantizer in consideration of a distribution of digital data, and the digital signal is encoded into a bitstream including frame length information useful upon digital signal encoding at a variable bitrate.

According to another aspect of the present invention, there is provided a computer program as set forth in claim 35 and a computer program embodied on a computer readable medium as set forth in claim 36.

Additional aspects and/or advantages of the invention will be set forth in part in the description which follows and, in part, will be apparent from the description, or may be learned by practice of the invention.

These and/or other aspects and advantages of the invention will become apparent and more readily appreciated from the hollowing description of the embodiments, taken in conjunction with the accompanying drawings of which:

FIG. 1 is a block diagram of a conventional digital signal encoding apparatus using an acoustic psychology model in the MPEG-1;
FIG. 2 is a block diagram of a conventional digital signal encoding apparatus using a single lookup table;
FIG. 3 is a block diagram of a digital signal encoding apparatus using a plurality of lookup tables and linear quantization by sections, according to an embodiment of the present invention;
FIG. 4 is a block diagram of a detailed structure of a linear quantization portion of FIG. 3;
FIG. 5 is a flowchart illustrating a digital signal encoding method using a plurality of lookup tables and linear quantization by sections, according to an embodiment of the present invention;
FIG. 6 is a flowchart illustrating an embodiment of an operation of selecting one of the lookup tables illustrated in FIG. 5;
FIGS. 7A and 7B are graphs illustrating occupancy rates for frequency bands of an input signal;
FIG. 8 is a flowchart illustrating an embodiment of an operation of allocating a number of bits allocated to each frequency band illustrated in FIG. 5;
FIG. 9 is a flowchart illustrating operation 560 shown in FIG. 5;
FIG. 10 illustrates a distribution of sub-band samples obtained by normalizing sample data;
FIG. 11 is a graph illustrating two sections into which the range of normalized values is divided;
FIG. 12 is a graph illustrating a quantizer designed according to a Lloyd-Max algorithm based on the distribution of FIG. 10;
FIG. 13 is a block diagram of a digital signal encoding apparatus having improvements in a bit allocation portion and a bit packing portion, according to another embodiment of the present invention;
FIG. 14 illustrates an example of a frame structure of a bitstream;
FIG. 15 illustrates another example of a frame structure of a bitstream;

FIG. 16 is a flowchart illustrating a digital signal encoding method in which a bit stream including frame length information is produced using a plurality of lookup tables, according to another embodiment of the present invention;

FIG. 17 is a block diagram of a digital signal encoding apparatus having improvements in a linear quantization portion and a bit packing portion ;

FIG. 18 is a flowchart illustrating a digital signal encoding method in which a bit stream including frame length information is produced using linear quantization by sections;

FIG. 19 is a block diagram of a digital signal encoding apparatus having improvements in a lookup table, a bit allocation portion, and a bit packing portion, according to another embodiment of the present invention;

FIG. 20 is a flowchart illustrating a digital signal encoding method in which a bit stream including frame length information is produced using a plurality of lookup tables and linear quantization by sections, according to another embodiment of the present invention;

FIG. 21 is a flowchart illustrating a method of producing a plurality of lookup tables;

FIG. 22 is a flowchart illustrating a method of producing a plurality of lookup tables;

FIG. 23 is a table illustrating a method of setting addresses used in a lookup table;

FIG. 24 is a table illustrating a method of producing a lookup table;

FIG. 25 is a block diagram of a digital signal decoding apparatus corresponding to a digital signal encoding apparatus in which linear quantization by sections is performed using a plurality of lookup tables;

FIG. 26 is a block diagram of a detailed structure of a linear dequantization portion of FIG. 25;

FIG. 27 is a flowchart illustrating a digital signal decoding method corresponding to a digital signal encoding method in which linear quantization by sections is performed using a plurality of lookup tables;

FIG. 28 is a flowchart illustrating an operation of dequantizing sample data;

FIG. 29 is a block diagram of a digital signal decoding apparatus corresponding to a digital signal encoding apparatus in which a bit stream including frame length information is produced using a plurality of lookup tables;

FIG. 30 is a block diagram of a bit stream analyzing portion of FIG. 29;

FIG. 31 is a flowchart illustrating a digital signal decoding method corresponding to a digital signal encoding method in which a bit stream including frame length information is produced using a plurality of lookup tables;

FIG. 32 is a block diagram of a digital signal decoding apparatus corresponding to a digital signal encoding apparatus in which a bit stream including frame length information is produced using a plurality of lookup tables and linear quantization by sections and to a digital signal encoding apparatus in which a bit stream including frame length information is produced using linear quantization by sections; and

FIG. 33 is a flowchart illustrating a digital signal decoding method corresponding to a digital signal encoding method in which a bit stream including frame length information is produced using a plurality of lookup tables and linear quantization by sections and to a digital signal encoding method in which a bit stream including frame length information is produced using linear quantization by sections.

Reference will now be made in detail to the embodiments of the present invention, examples of which are illustrated in the accompanying drawings, wherein like reference numerals refer to the like elements throughout. The embodiments are described below to explain the present invention by referring to the figures.

A digital signal encoding/decoding method and apparatus according to an embodiment of the present invention will now be described in detail with reference to the accompanying drawings, in which embodiments of the invention are shown.

A digital signal encoding apparatus according to an embodiment of the present invention is obtained by improving a bit allocation portion, a quantization portion, and a bit packing portion of a general digital signal encoding apparatus, which further includes a data transformation portion. To be more specific, the improved bit allocation portion calculates a number of bits allocated for a unit in which a digital input signal is quantized (hereinafter, referred as a quantization unit), using a plurality of lookup tables produced based on characteristics of an input signal. The improved quantization portion performs linear quantization by sections. The bit packing portion produces a bitstream including information about a length of a frame.

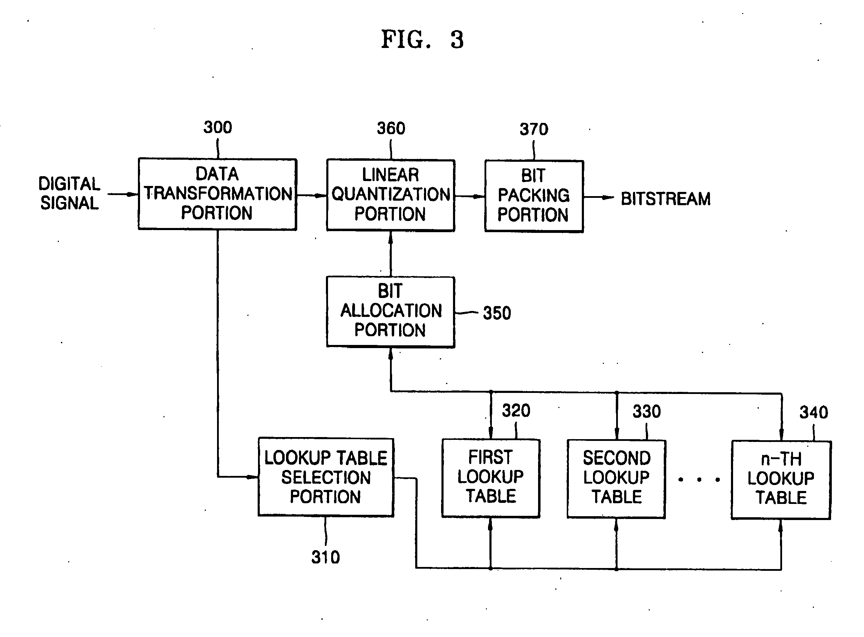

Accordingly, an embodiment of the present invention provides encoding apparatuses according to 3 embodiments, which are: an encoding apparatus including the improved bit allocation portion and the improved linear quantization portion; an encoding apparatus including the improved bit allocation portion and the improved bit packing portion; as an example: an encoding apparatus including the improved linear quantization portion and the improved bit packing portion; and an encoding apparatus including the improved bit allocation portion, the improved linear quantization portion, and the improved bit packing portion. First, the digital signal encoding apparatus including the improved bit allocation portion and the improved linear quantization portion will be described with reference to FIG. 3. Referring to FIG. 3, the digital signal encoding apparatus includes a data transformation portion 300, a lookup table selection portion 310, first through n-th lookup tables 320, 330, and 340, a bit allocation portion 350, a linear quantization portion 360, and a bit packing portion 370.

The data transformation portion 300 transforms a digital input signal to remove redundant information among signals. The digital input signal may be a pulse-code modulation (PCM) sampled signal. The PCM sampled signal, which is a time-domain input signal, is transformed into a frequency-domain signal, which is divided by a predetermined number of frequency bands, using sub-band filters. The digital input signal is quantized in units of a frequency band. Hereinafter, the frequency bands will be used as an example of a quantization unit. The digital signal, for example, the PCM sampled signal, may be transformed through discrete cosine transform (DCT), modified DCT (MDCT), fast Fourier transform (FFT), or the like, instead of using the sub-band filters, so that redundant information can be removed from data.

The lookup tables 320, 330, and 340 are produced based on characteristics of the input signal. The lookup tables 320, 330, and 340 store the numbers of bits allocated to encode quantization units of the input signal, in a predetermined number of addresses. Since the input signal is transformed using the sub-band filters, the quantization unit of the input signal is a frequency band. The characteristics of the input signal may be the number of frequency bands among the frequency bands of the input signal, whose occupancy rates are no greater than or no less than a predetermined reference value. The occupancy rate of each frequency band may be a larger value between an occupancy rate of a squared scale factor of the frequency band and an occupancy rate of a mean power of the frequency band. The addresses used in each of the lookup tables are set to values indicating characteristics of the frequency bands of the input signal. For example, the addresses used in each of the lookup tables may be set to a variance of each frequency band, a scale factor of each frequency band, a squared scale factor of each frequency band, a mean value of sampled input signals within each frequency band, a mean power of the sampled input signals within each frequency band, a larger value between an occupancy rate of the scale factor of each frequency band and an occupancy rate of the mean value of the input signals within each frequency band, or a larger value between an occupancy rate of the squared scale factor of each frequency band and an occupancy rate of the mean power of the input signals within each frequency band.

The occupancy rate of the scale factor of each frequency band, $SR_{scf}$, the occupancy rate of the mean value of the input signals within each frequency band, $SR_{mean}$, the occupancy rate of the squared scale factor, $SR_{squared\_scf}$, and the occupancy rate of the mean power of the input signals within each frequency band, $SR_{mean\_power}$, can be calculated as in Equation 1:

$$SR_{squared\_scf}[ch][sb] = \frac{squared\_scf[ch][sb]}{\sum_{ch}\sum_{sb} squared\_scf[ch][sb]}$$

$$SR_{mean\_pwr}[ch][sb] = \frac{mean\_pwr[ch][sb]}{\sum_{ch}\sum_{sb} mean\_pwr[ch][sb]}$$

wherein scf denotes a scale factor, mean denotes a mean value, ch denotes a left or right channel which calculates an occupancy rate from an audio signal, and sb denotes a frequency band having the occupancy rate.

The lookup table selection portion 310 selects one among the lookup tables 320, 330, and 340 according to the characteristics of the input signal, which have been considered when producing the lookup tables 320, 330, and 340.

The bit allocation portion 350 calculates address values for quantization units of the input signal, e.g., address values for the frequency bands of the input signal obtained using the sub-band filters, extracts numbers of allocated bits for the frequency bands corresponding to the calculated address values from the selected lookup table, and allocates the extracted numbers of bits to the corresponding frequency bands. The addresses for the frequency bands are set upon production of the lookup tables 320, 330, and 340. Hence, the bit allocation portion 350 calculates values indicating the characteristics of the frequency bands of the input signal to serve as the address values of the frequency bands.

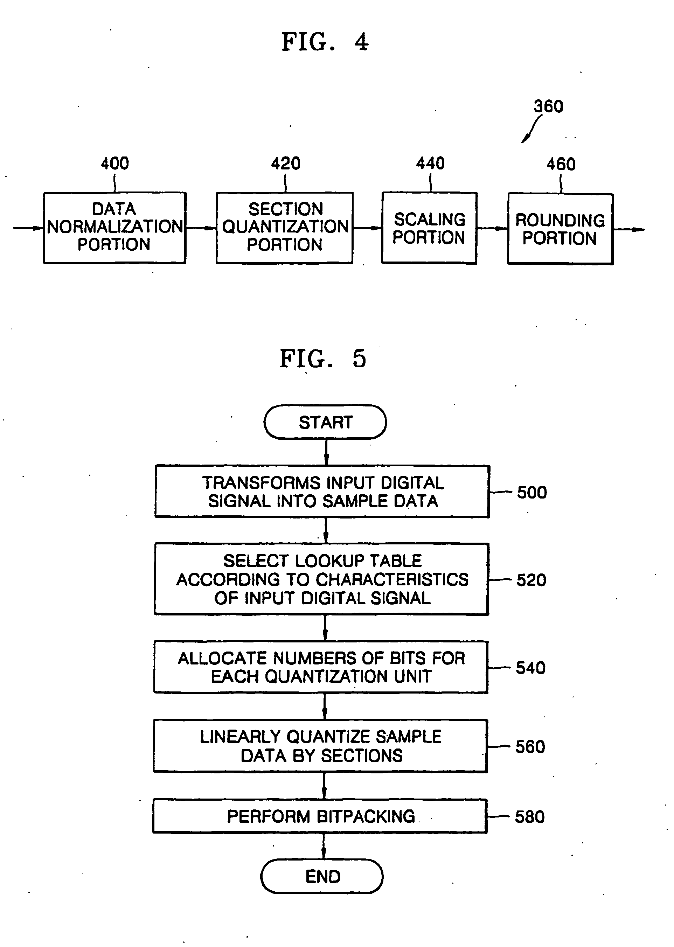

The linear quantization portion 360 divides a distribution of sample data values into predetermined sections based on the quantizing unit, and linearly quantizes sample data from which repeated information is removed by the data transformation portion 300, using the numbers of bits allocated for the quantization units by the bit allocation portion 350. Referring to FIG. 4, the linear quantization portion 360 includes a data normalization portion 400, a section quantization portion 420, a scaling portion 440, and a rounding portion 460.

FIG. 4 is a block diagram of a detailed structure of the linear quantization portion 360. The data normalization portion 400 normalizes the sample data produced by the data transformation portion 300, using a predetermined scale factor. The scale factor is an integer determined by a predetermined function of a value greater than or equal to a maximum absolute value among sample data values within the quantizing unit. The section quantization portion 420 divides the range of normalized values into predetermined sections, and applies linear functions to the predetermined sections of the data normalized by the data normalization portion 400. The scaling portion 440 scales values generated by the section quantization portion 420 using the numbers of bits allocated by the bit allocation portion 350. The rounding portion 460 rounds the scaled sampling values to the nearest whole number using the numbers of bits allocated and generates quantized sample data.

The bit packing portion 370 codes the data linearly quantized by the linear quantization portion 360 to produce a bit stream. The coding may be a Huffman coding.

The digital signal encoding apparatus using the plurality of lookup tables may further include a number-of-bits adjuster (not shown). The number-of-bits adjuster calculates the number of allocated bits for an entire input signal, which is a sum of the numbers of bits allocated to the frequency bands by the bit allocation portion 350, compares the calculated number of allocated bits with a required number of bits to be allocated for the entire input signal, which is determined by an encoding rate required by the encoding apparatus, and adjusts the number of bits allocated to each of the frequency bands according to the comparison result.

FIG. 5 is a flowchart illustrating a digital signal encoding method performed in the digital signal encoding apparatus of FIG. 3, according to an embodiment of the present invention. Referring to FIGS. 3 and 5, first, the data transformation portion 300 transforms an input digital signal so that redundant information can be removed from the input digital signal, in operation 500. For example, a time-domain digital input signal is transformed into a predetermined number of frequency bands using sub-band filters, which serve as a band analysis filter.

In operation 520, the bit allocation portion 350 calculates address values of the frequency bands of the input signal, which are quantization units. The address values of the frequency bands indicate characteristics of the frequency bands set as addresses when the lookup tables 320, 330 and 340 are produced. Each of the address values may be a variance of each frequency band, a scale factor of each frequency band, a squared scale factor of each frequency band, a mean value of input signals in each frequency band, a mean power of input signals in each frequency band, a larger value between an occupancy rate of a scale factor of each frequency band and an occupancy rate of a mean value of input signals in each frequency band, or a larger value between an occupancy rate of a squared scale factor of each frequency band and an occupancy rate of a mean power of input signals in each frequency band.

Relations between characteristics of frequency bands, which can be set as the address values of the frequency bands, and the number of allocated bits for each frequency band will now be described. A variance characteristic shows how near a distribution of an input signal is to an average distribution. If the variance is large, a dynamic area of the input signal is large. Accordingly, to reduce quantization noise, more bits must be allocated. If the variance is relatively small, even though the bit allocation amount is small, not as much quantization noise is generated. A mean power characteristic has a similar concept to a mean characteristic. However, because a mean value of an input signal is generally 0 in a case of a sine wave, a mean power value instead of the mean value is used as a characteristic of a frequency band. More bits are allocated to a frequency band whose mean power value is large. A scale factor is defined as a value corresponding to the largest sample value per frequency band, and more bits are allocated to a frequency band whose scale factor is large.

Still in operation 520, the lookup table selection portion 310 selects one of the plurality of lookup tables 320, 330 and 340 according to the characteristic of the input digital signal. The characteristic of the input signal, which is a basis of the lookup table selection, is considered when the plurality of lookup tables 320, 330 and 340 are produced, and may be set to the number of frequency bands among the frequency bands of the input signal, whose occupancy rates are no more than or no less than a predetermined reference value. The occupancy rate of each frequency band may be set to a larger value between an occupancy rate of a scale factor of each frequency band and an occupancy rate of a mean value of input signals in each frequency band or a larger value between an occupancy rate of a squared scale factor of each frequency band and an occupancy rate of a mean power of input signals in each frequency band, which are calculated in Equation 1.

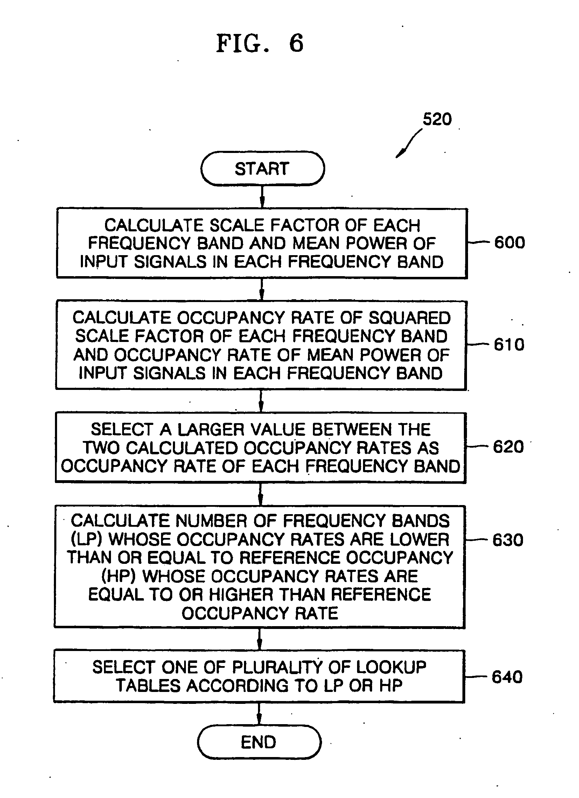

FIG. 6 is a flowchart illustrating an embodiment of an operation of selecting one of the lookup tables illustrated in FIG. 5 (operation 520). Referring to FIG. 6, a scale factor of each frequency band and a mean power of input signals in each frequency band are calculated in operation 600. Then, an occupancy rate of a squared scale factor of each frequency band and an occupancy rate of a mean power of input signals in each frequency band are calculated as shown in Equation 1, in operation 610.

Thereafter, a larger value between the two calculated occupancy rates is selected as an occupancy rate of each frequency band, in operation 620. Next, the number of frequency bands (LP) whose occupancy rates are lower than or equal to a predetermined reference occupancy rate and the number of frequency bands (HP) whose occupancy rates are equal to or higher than the predetermined reference occupancy rate are calculated, in operation 630. The numbers of frequency bands, LP and HP, serve as values indicating the characteristics of the input signal on which the lookup table selection is based.

In operation 640, one of a plurality of lookup tables is selected according to the numbers of frequency bands, LP and HP, which indicate the characteristics of the input signal. If the number of frequency bands, LP, is large, sampled input signals are concentrated in a specific frequency band. Accordingly, a lookup table indicating allocation of more bits for frequency bands where sampled input signals are concentrated is selected. Also, if the number of frequency bands, HP, is small, sampled input signals are concentrated in a specific frequency band. Accordingly, a lookup table indicating allocation of more bits for frequency bands where sampled input signals are concentrated is selected.

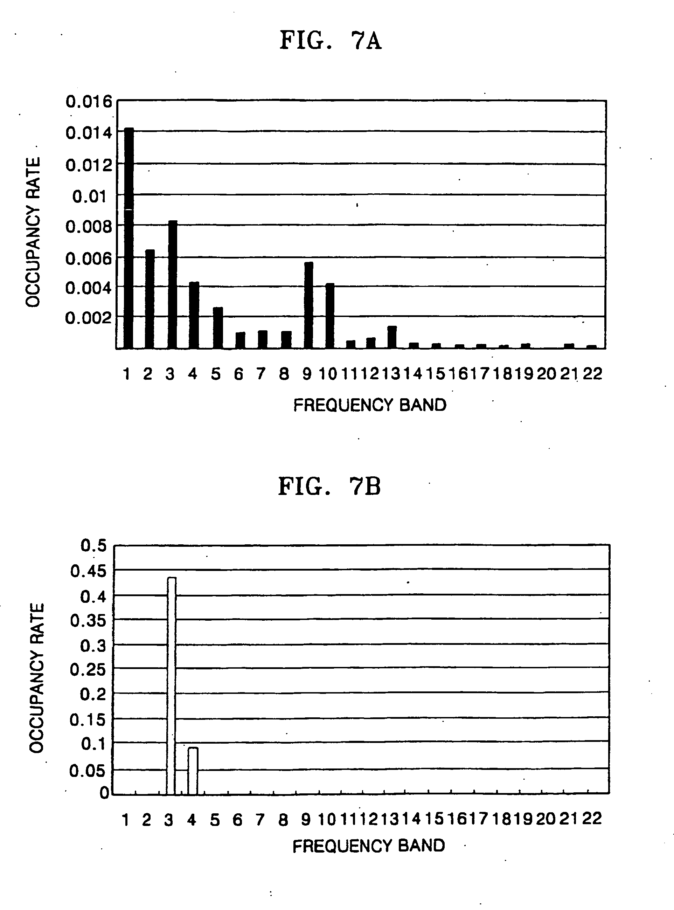

FIGS. 7A and 7B are graphs showing occupancy rates of frequency bands of an input signal. FIG. 7A deals with sampled input signals having a general characteristic. Referring to FIG. 7A, since LP is small and HP is large, a lookup table indicating allocation of similar numbers of bits for all frequency bands is selected.

FIG. 7B deals with sampled input signals which are concentrated in a specific frequency band. Referring to FIG. 7B, since LP is large and HP is small, a lookup table indicating allocation of many bits for a specific frequency band is selected.

After a suitable lookup table is selected according to the characteristics of the input digital signal in operation 520, the bit allocation portion 350 extracts the numbers of allocated bits corresponding to the address values for the frequency bands from the selected lookup table and allocates the numbers of bits to the frequency bands, in operation 540.

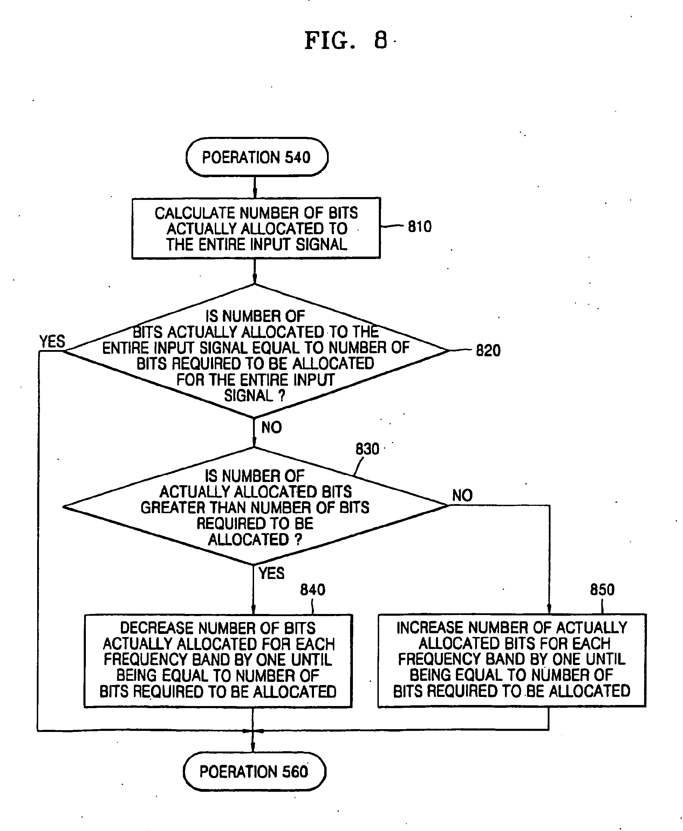

To match the total number of bits allocated for the encoded input signal to the number of bits required to be allocated, which depends on a compression rate, an operation of adjusting the number of bits allocated for each frequency band may be performed after operation 540. This operation will now be described in detail with reference to FIG. 8.

FIG. 8 is a flowchart illustrating an operation of matching a number of bits actually allocated to an input signal to a number of bits required to be allocated to the input signal, after operation 540 of FIG. 5. Referring to FIG. 8, after bits, the number of which is obtained from the selected lookup table, are allocated to each frequency band in operation 540 of FIG. 5, the number of bits actually allocated to the entire input signal is calculated by summing the numbers of bits allocated to the frequency bands, in operation 810.

In operation 820, it is determined whether the number of bits actually allocated to the entire input signal, which is calculated in operation 810, is equal to the number of bits required to be allocated, which depends upon a compression rate for encoding. For example, when the total number of bits for the input signal is 100 and a compression rate is 50%, 50 bits are required to be allocated for the input signal. If the number of bits actually allocated to the entire input signal is equal to the number of bits required to be allocated, bits are allocated to each frequency band according to the numbers of bits allocated in operation 540.

On the other hand, if the number of bits actually allocated to the entire input signal is different from the number of bits required to be allocated, another determination is made as to whether the number of actually allocated. bits is greater than the number of bits required to be allocated, in operation 830. If the number of actually allocated bits is greater than the number of bits required to be allocated, the number of actually allocated bits for each frequency band decreases 1 until being equal to the number of bits required to be allocated, in operation 840. If the number of actually allocated bits is smaller than the number of bits required to be allocated, the number of actually allocated bits for each frequency band increases 1 until being equal to the number of bits required to be allocated, in operation 850.

Referring back to FIG. 5, when the number of bits to be allocated for each frequency band is finally determined, the distribution of digital signal values for each quantization unit, for example, each frequency band obtained when using sub-band filters, is divided into predetermined sections, and the digital signal values in each section are linearly quantized using the number of bits to be allocated for each quantization unit, in operation 560.

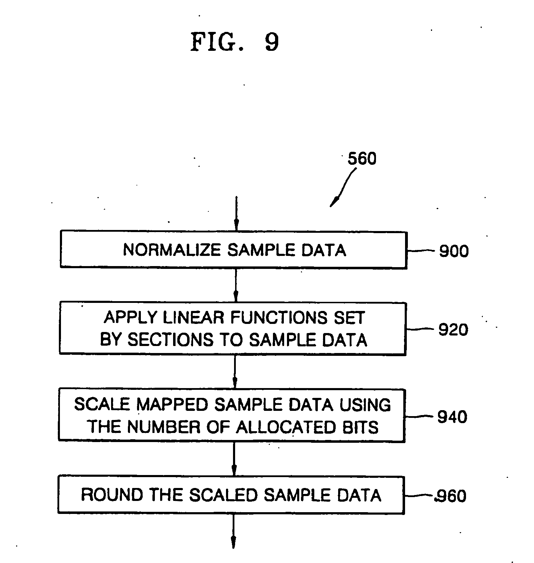

FIG. 9 is a flowchart illustrating operation 560 shown in FIG. 5. Referring to FIGS. 4 and 9, first, the data normalization portion 400 normalizes sample data obtained by the data transformation portion 300, using a scale factor of each quantization unit, that is, each frequency band obtained when using sub-band filters, in operation 900. For example, assume that the output sample values that are sub-band filtered using the subband filters of the data transformation portion 300 are 24, -32, 4, and 10. The maximum absolute value of the output sample values is 32. When the sample values are normalized using a scale factor corresponding to the maximum value 32, the sample values become 0.75, -1, 0.125, and 0.3125. Here, the scale factor may be determined as follows. In a predetermined formula $2^{x/4}$, wherein x is a scale factor, when x is incremented by one from 0 to 31, the value of the formula $2^{x/4}$ is determined according to 32 values of x. That is, if x=0, the value of the formula $2^{x/4}$ is 1, if x=1, the value of the formula $2^{x/4}$ is 1.18, if x=2, the value of the formula $2^{x/4}$ is 1.414, if x=3, the value of the formula $2^{x/4}$ is 1.68, if x=4, the value of the formula $2^{x/4}$ is 2, etc. When all the values of the formula $2^{x/4}$ are calculated, it can be seen that as x increments by one, the value of the formula $2^{x/4}$ increments by 1.5dB. In the present example, if the value of the formula $2^{x/4}$ corresponding to the absolute maximum value 32 is 32, the scale factor x will be 20. Therefore, one value of the scale factor is determined in each subband.

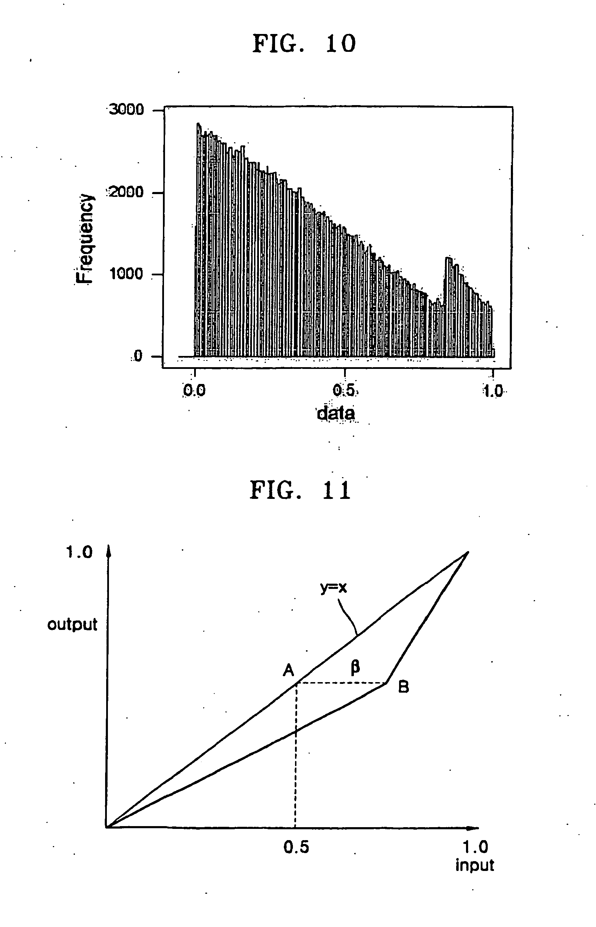

FIG. 10 is a graph illustrating the distribution of subband samples used to normalize the sample data. The normalized samples, as shown in FIG. 10, are not uniformly distributed. Therefore, they cannot be optimally quantized using a linear quantizer.

Therefore, the section quantizing portion 420 divides the range of the normalized values into predetermined sections and transforms the sample data normalized in operation 900 by applying linear functions set for the predetermined sections to the sample data, in operation 920. For example, the range of the normalized values in FIG. 10 is 0.0-1.0, and FIG. 11 illustrates the normalized value range divided into two sections. In the graph of FIG. 11 illustrating a linear function given by y=x, a point away from a point A on the graph y=x corresponding to the mid point (x=0.5) on the x-axis by β in the x-axis direction is indicated by B. Thus, if β is 0.1, the x-axis is divided into two sections: one section from 0-0.6 (section1) and the other section from 0.6 to 1.0 (section 2). Two linear functions are applied to the two sections in such a way that one linear function is applied to one section. The value of β may be set according to the distribution of samples. β indicates how much the linear function y=x at the middle point of the normalized value range is inclined with respect to the x-axis. In another form, β may indicate how much the linear function y=x at the middle point of the normalized value range is inclined with respect to the y-axis.

The linear functions can generally be expressed as $y = \dfrac{ax}{(a-2b)}$ and $y = \dfrac{x'}{(1+2b)} + \dfrac{2b}{(1+2b)}$ . Here, a denotes the range of normalized values, and b denotes section displacement from the center of a. In the present example, if the β is 0.1, a first linear function $y=f_1(x)$ is $y = \dfrac{5}{6} \times x$ in section 1, and a second linear function $y=f_2(x)$ is

$$y = \dfrac{5}{4}x - \dfrac{1}{4}$$ in section 2. The linear functions are applied to sample values in the corresponding sections. In the present example, the sample values 0.125 and 0.3125 are included in section 1 and mapped by applying the first linear function $y=f_1(x)$, and the sample values 0.75 and -1 are included in section 2 and mapped by applying the second linear function $y=f_2(x)$.

In operation 940, the mapped values are scaled in the scaling portion 440 using the number of bits allocated by the bit allocating portion 350. For example, if the bit allocation information is 3, the sample values mapped by applying the linear functions of the corresponding sections are multiplied by 8, since 0 through 7 can be expressed.

In operation 960, the sample values scaled in operation 940 are rounded to obtain quantized sample values. The rounded value is always an integer. For example, if the number of bits to be allocated is 3, a rounded value is one from 0 to 7, is expressed with 3 bits, and is the final quantized sample value.

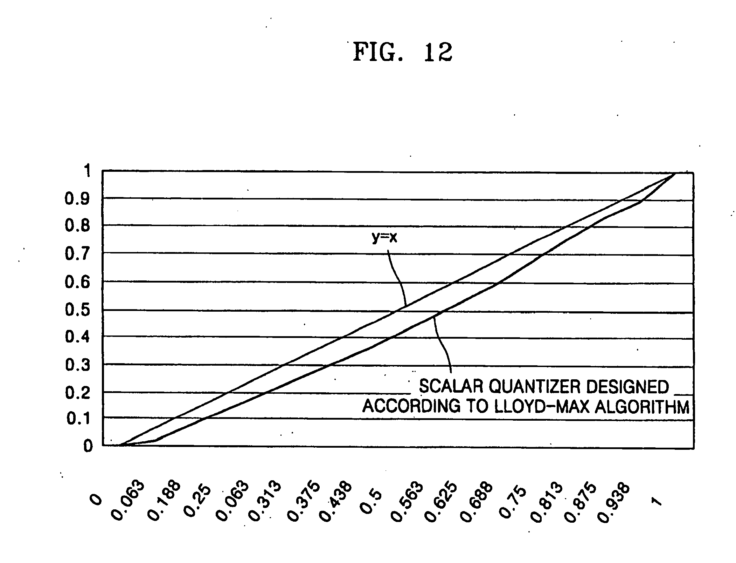

FIG. 12 is a graph produced using a quantizer designed according to a Lloyd-Max algorithm based on the distribution of FIG. 10. As illustrated in FIG. 12, the produced graph bulges downwards toward the x-axis from the linear function y=x.

Referring back to FIG. 5, in operation 580, the data linearly quantized as described above together with side information is encoded into a bit stream using a data encoding method, such as, a Huffman encoding, in the bit packing portion 370 of FIG. 3. Preferably, the side information includes a scale factor of each frequency band and the number of bits allocated for each frequency band.

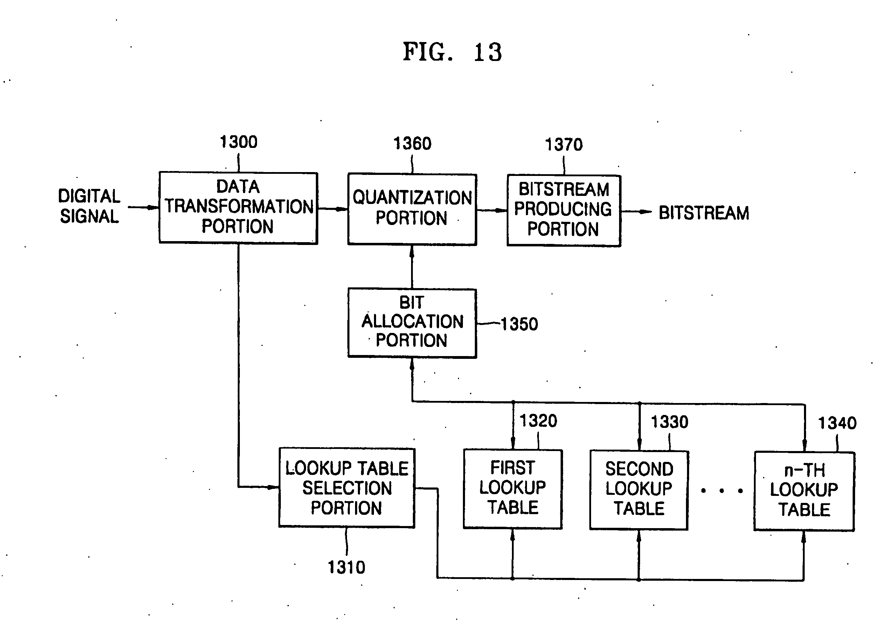

Hereinafter, a digital signal encoding apparatus having improvements in a bit allocation portion and a bit packing portion will be described with reference to FIG. 13. Referring to FIG. 13, this digital signal encoding apparatus includes a data transformation portion 1300, a lookup table selection portion 1310, a plurality of lookup tables 1320, 1330, and 1340, a bit allocation portion 1350, a quantization portion 1360, and a bitstream producing portion 1370.

The data transformation portion 1300, the lookup table selection portion 1310, the lookup tables 1320, 1330, and 1340, and the bit allocation portion 1350 operate equally to the data transformation portion 300, the lookup table selection portion 310, the lookup tables 320, 330, and 340, and the bit allocation portion 350 of FIG. 3, respectively, so they will not be described again.

The quantization portion 1360, which is a general quantizer, quantizes the input signal using bits allocated for each quantization unit, e.g., each frequency band when using sub-band filters.

The bitstream producing portion 1370 produces a bitstream comprised of frames from the quantized data and side information. Information about a frame length is located at a tail portion of the bitstream. Preferably, the side information includes a scale factor for each frequency band and the number of bits allocated for each frequency band.

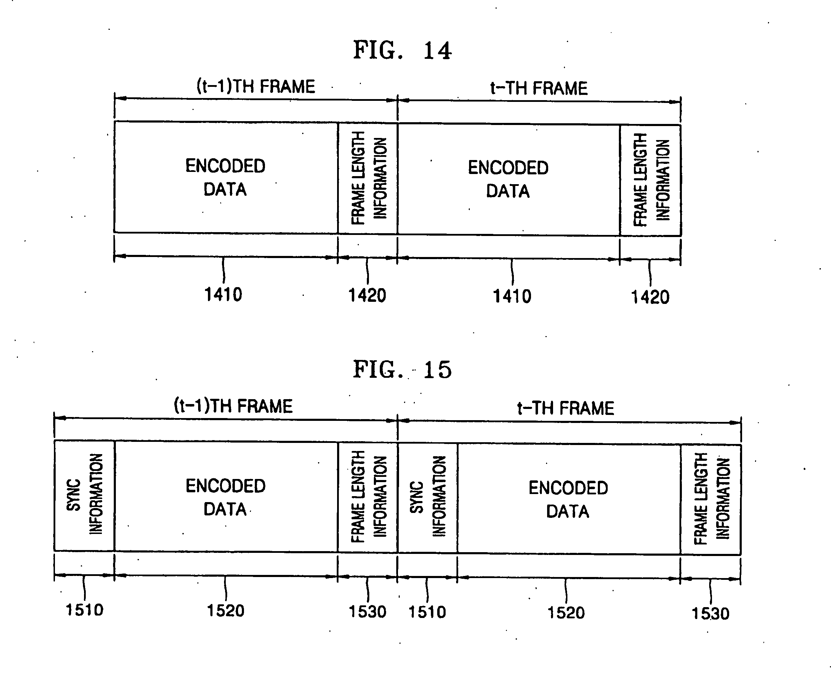

FIG. 14 illustrates an example of a frame structure of a bitstream. Each frame is comprised of a first area 1410, which stores encoded data, and a second area 1420, which stores encoded information about a frame length. A size of the second area 1420 is constant for all frames, and a size of the first area 1410 may vary when an encoding rate of frames is a variable bitrate. FIG. 15 illustrates another example of a frame structure of a bitstream. Each frame is comprised of a first area 1510, which stores sync information, a second area 1520, which stores encoded data, and a third area 1530, which stores encoded information about a frame length. Sizes of the first and third area 1510 and 1530 are constant for all frames, and a size of the second area 1520 may vary when an encoding rate of frames is a variable bitrate. When a frame includes sync information as in the example of FIG. 15, and a digital signal reproducing apparatus receives an external impact during reproduction of a digital signal, a reverse search for effective data to be reproduced can become more reliable and more accurate.

The digital signal encoding apparatus of FIG. 13 may further include a number-of-bits adjusting portion (not shown). The number-of-bits adjusting portion calculates the number of allocated bits for an entire input signal, which is a sum of the numbers of bits allocated to the frequency bands by the bit allocation portion 1350, compares the calculated number of allocated bits with a required number of bits to be allocated for the entire input signal, which is determined by an encoding rate required by the encoding apparatus, and adjusts the number of bits allocated for each of the frequency bands according to the comparison result.

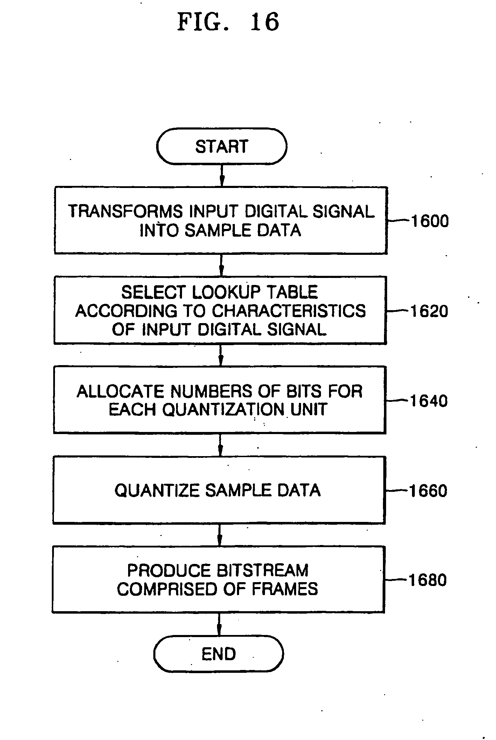

FIG. 16 is a flowchart illustrating a digital signal encoding method in which a bit stream including frame length information is produced using a plurality of lookup tables, according to another embodiment of the present invention. This digital signal encoding method will now be described by referring to FIGS. 13 and 16.

Operations 1600 through 1640 are the same as operations 500 through 540 of FIG. 5, so they will not be described herein.

To match the total number of bits allocated for the encoded input signal to a required number of bits to be allocated, which depends on a compression rate, an operation of comparing the total number of bits allocated for the encoded input signal with the required number of bits to be allocated and adjusting the number of bits allocated for each frequency band according to a result of the comparison may be performed after operation 1640.

After bits are allocated to each frequency band in operation 1640 or after the number of bits allocated to each frequency band is adjusted as necessary, data transformed by the data transformation portion 1300 is quantized, for example, in units of a frequency band when using sub-band filters, using the number of bits allocated to each frequency band, in operation 1660.

Thereafter, a bitstream comprised of frames is produced from the quantized data and predetermined side information in the bitstream producing portion 1370, in operation 1680. Each frame in a bitstream includes information about a frame length located in a tail area of the frame as shown in FIG. 14 and may further include sync information used for inter-frame synchronization located in a head area of the frame as shown in FIG. 15. Preferably, the predetermined side information includes a scale factor of each band and the number of bits allocated for each band.

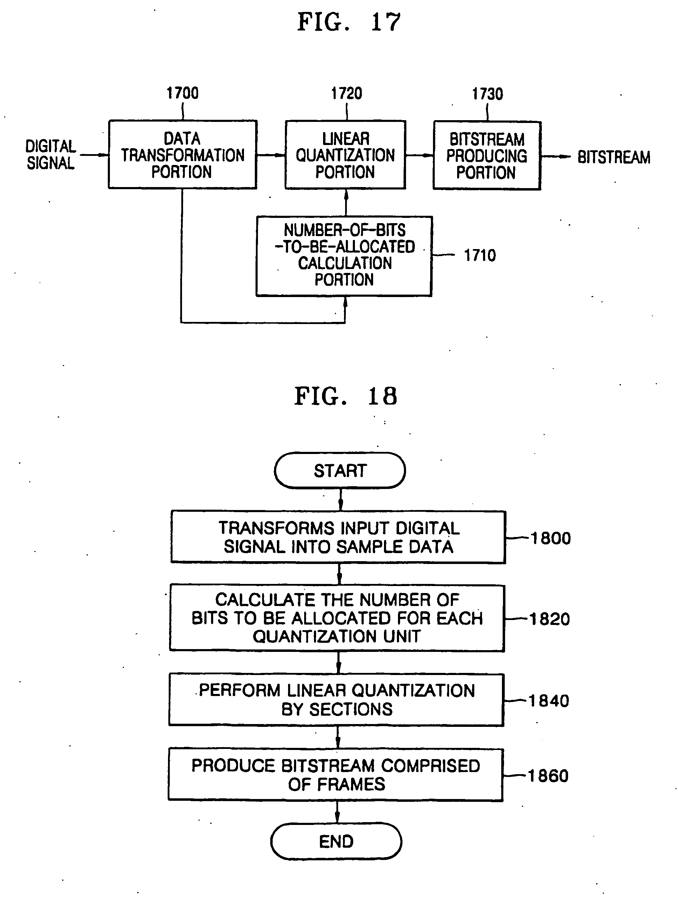

FIG. 17 is a block diagram of a digital signal encoding apparatus having improvements in a linear quantization portion and a bit packing portion. This digital signal encoding apparatus includes a data transformation portion 1700, a number-of-bits-to-be-allocated calculation portion 1710, a linear quantization portion 1720, and a bitstream production portion 1730.

The data transformation portion 1700 and the linear quantization portion 1720 operate equally to the data transformation portion 300 and the linear quantization portion 360 of FIG. 3, respectively, and the bitstream production portion 1730 operates equally to the bitstream production portion 1370 of FIG. 13. Accordingly, the data transformation portion 1700, the linear quantization portion 1720, and the bitstream production portion 1730 will not be described herein.

The number-of-bits-to-be-allocated calculation portion 1710 is the same as a bit allocation portion of a general digital signal encoding apparatus. In other words, the number-of-bits-to-be-allocated calculation portion 1710 calculates the number of bits to be allocated for each quantization unit in consideration of the importance of a signal. Also, the number-of-bits-to-be-allocated calculation portion 1710 omits detailed information lowly sensitive to humans using hearing characteristics of humans and differentiates the numbers of bits to be allocated for frequency bands so that the amount of data to be encoded can be reduced. Preferably, the number-of-bits-to-be-allocated calculation portion 1710 calculates the numbers of bits to be allocated for frequency bands, in consideration of the psychoacoustic perspective.

FIG. 18 is a flowchart illustrating a digital signal encoding method in which a bit stream including frame length information is produced using linear quantization by sections. This digital signal encoding method will now be described with reference to FIGS. 17 and 18.

Operations 1800 and 1840 of FIG. 18 are the same as operations 500 and 540 of FIG. 5, and operation 1860 of FIG. 18 is the same as operation 1680 of FIG. 16. Hence, operations 1800, 1840, and 1860 will not be described in detail herein. When a digital audio signal is transformed so that redundant information is removed from the digital signal in operation 1800, the number-of-bits-to-be-allocated calculation portion 1710 calculates the number of bits to be allocated for each quantization unit considering the importance of the audio signal, in operation 1820. For example, the quantization unit may be a sub-band when using sub-band filters. The importance of the digital signal, particuiariy, the audio signal, is decided considering the psychoacoustic perspective based on hearing characteristics of humans. Therefore, more bits are allocated to frequencies to which humans are highly sensitive and fewer bits are allocated to rest of the frequencies.

After the number of bits to be allocated for each frequency band is calculated in 1820, linear quantization by sections is performed in operation 1840, and a bitstream including information about a frame length is produced in operation 1860.

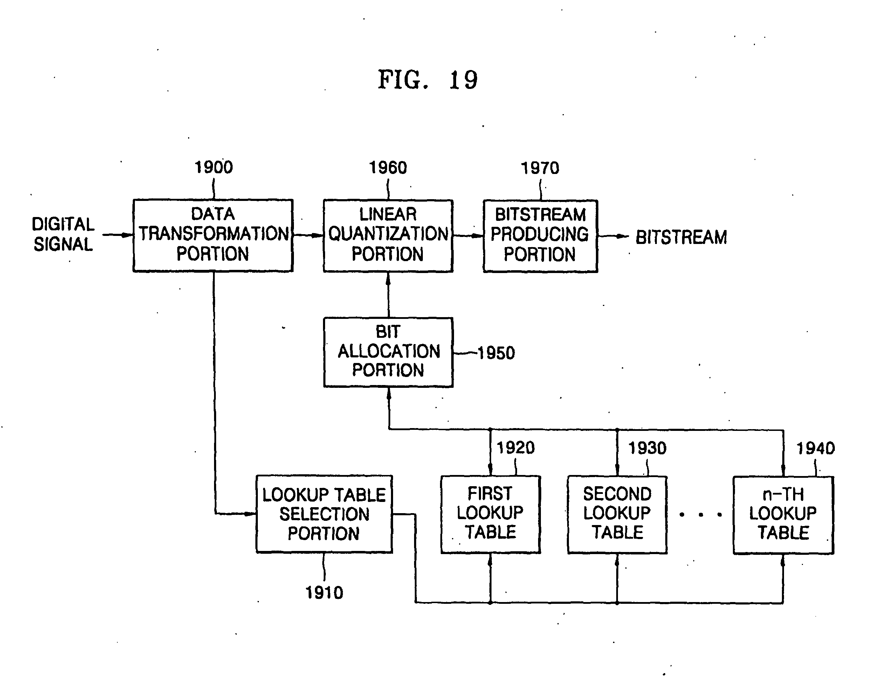

FIG. 19 is a block diagram of a digital signal encoding apparatus having improvements in a lookup table, a bit allocation portion, and a bit packing portion, according to another embodiment of the present invention. This digital signal encoding apparatus includes a data transformation portion 1900, a lookup table selection portion 1910, a plurality of lookup tables 1920, 1930, and 1940, a bit allocation portion 1950, a linear quantization portion 1960, and a bitstream producing portion 1970.

The data transformation portion 1900, the lookup table selection portion 1910, the lookup tables 1920, 1930, and 1940, the bit allocation portion 1950, and the linear quantization portion 1960 are the same as the data transformation portion 300, the lookup table selection portion 310, the lookup tables 320, 330, and 340, the bit allocation portion 350, and the linear quantization portion 360 of FIG. 3, respectively, in their functions and operations. The bitstream producing portion 1970 is the same as the bit packing portion 1370 of FIG. 13 in its function and operation. Hence, these elements of the digital signal encoding apparatus of FIG. 19 will not be described herein.

The digital signal encoding apparatus of FIG. 19 may include the above-described number-of-bits adjusting portion (not shown). The number-of-bits adjusting portion calculates the number of allocated bits for an entire input signal, which is a sum of the numbers of bits allocated to the frequency bands by the bit allocation portion 1950, compares the calculated number of allocated bits with a required number of bits to be allocated for the entire input signal, which is determined by an encoding rate required by the encoding apparatus, and adjusts the number of bits allocated for each of the frequency bands according to the comparison result.

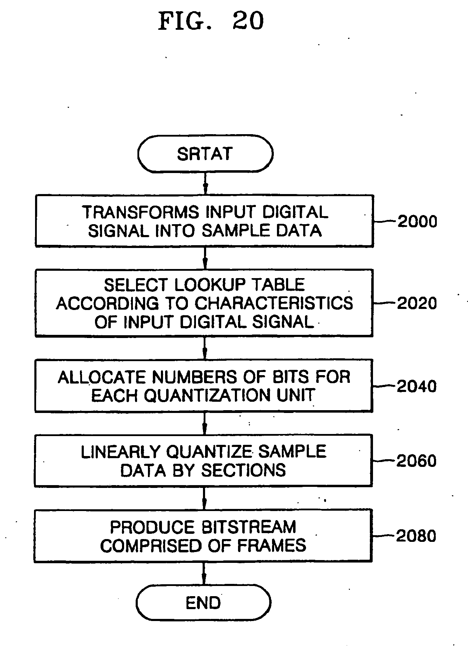

FIG. 20 is a flowchart illustrating a digital signal encoding method in which a bit stream including frame length information is produced using a plurality of lookup tables and linear quantization by sections, according to another embodiment of the present invention. This digital signal encoding method will now be described with reference to FIGS. 13 and 20. Operations 2000 through 2060 of FIG. 20 are the same as operations 500 through 560 of FIG. 5, respectively, and operation 2080 is the same as operation 1680 of FIG. 16, so they will not be described in detail herein. To match the total number of bits allocated for the encoded input signal to a required number of bits to be allocated, which depends on a compression rate, an operation of comparing the total number of bits allocated for the encoded input signal with the required number of bits to be allocated and adjusting the number of bits allocated for each frequency band according to a result of the comparison may be performed after operation 2040.

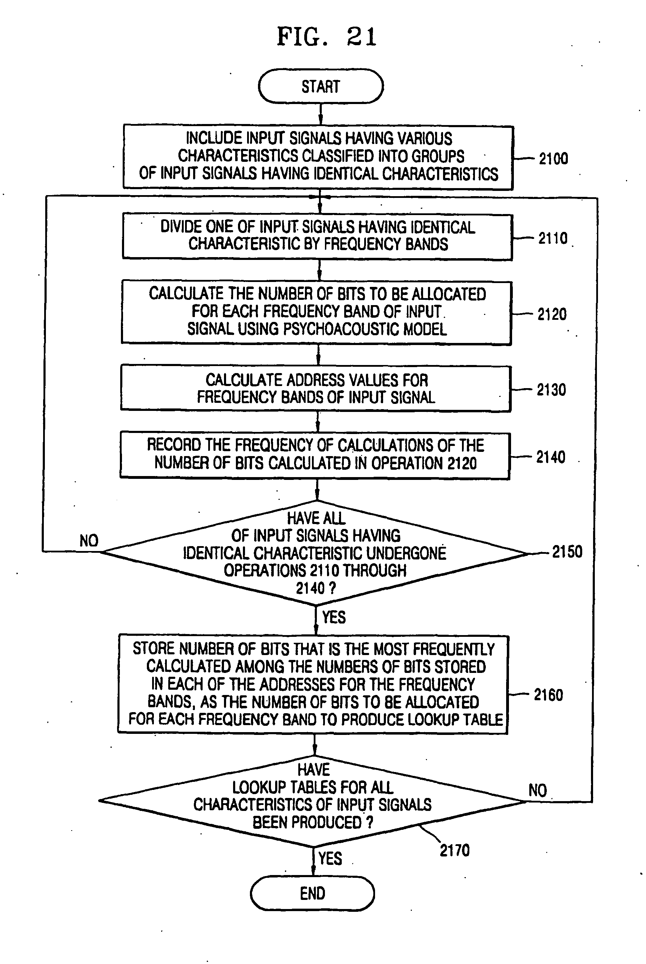

FIG. 21 is a flowchart illustrating a method of producing the plurality of lookup tables. As illustrated in FIG. 21, a predetermined number of input signals having various characteristics are classified into groups of input signals having identical characteristics, in operation 2100. The characteristics of the input are the same as in the above description of the lookup tables.

In operation 2110, one of the characteristics of the input signals is selected, and one of input signals having the selected characteristic is divided by frequency bands. In operation 2120, the number of bits to be allocated for each frequency band of the input signal is calculated using a psychoacoustic model. The calculation of the number of bits to be allocated for each frequency band in operation 2120 is the same as an operation of the psychoacoustic model 110 of FIG. 1, so it will not be described herein.

In operation 2130, address values for the frequency bands of the input signal are calculated. The address values are set to values indicating characteristics of the frequency bands of the input signal. The address values are the same as in the above description of the lookup tables.

In operation 2140, the numbers of bits to be allocated to the frequency bands calculated in operation 2120 are stored in addresses corresponding to the address values of the frequency bands calculated in operation 2130, and the frequency of calculations of the stored number of bits to be allocated for each frequency band is recorded.

In operation 2150, it is determined whether all of the input signals having the selected characteristic have undergone operations 2110 through 2140. If all of the input signals having the selected characteristic have not yet undergone operations 2110 through 2140, operations 2110 through 2140 are repeated.

On the other hand, if all of the input signals having the selected characteristic have undergone operations 2110 through 2140, a number of bits to be allocated that is the most frequently calculated among the numbers of bits stored in the addresses for each frequency band is stored as the number of bits to be allocated for each frequency band to produce a lookup table, in operation 2160. After operation 2160, addresses which record 0 as the number of bits allocated may be excluded from the produced lookup table. Also, when identical numbers of allocated bits are recorded in consecutive addresses, only addresses where different numbers of allocated bits are recorded may be stored in a lookup table to produce a small-sized lookup table.

In operation 2170, it is determined whether lookup tables for all characteristics of the input signals have been produced. If all of the lookup tables have not yet been produced, operations 2110 through 2160 are repeated until all of the lookup tables are produced.

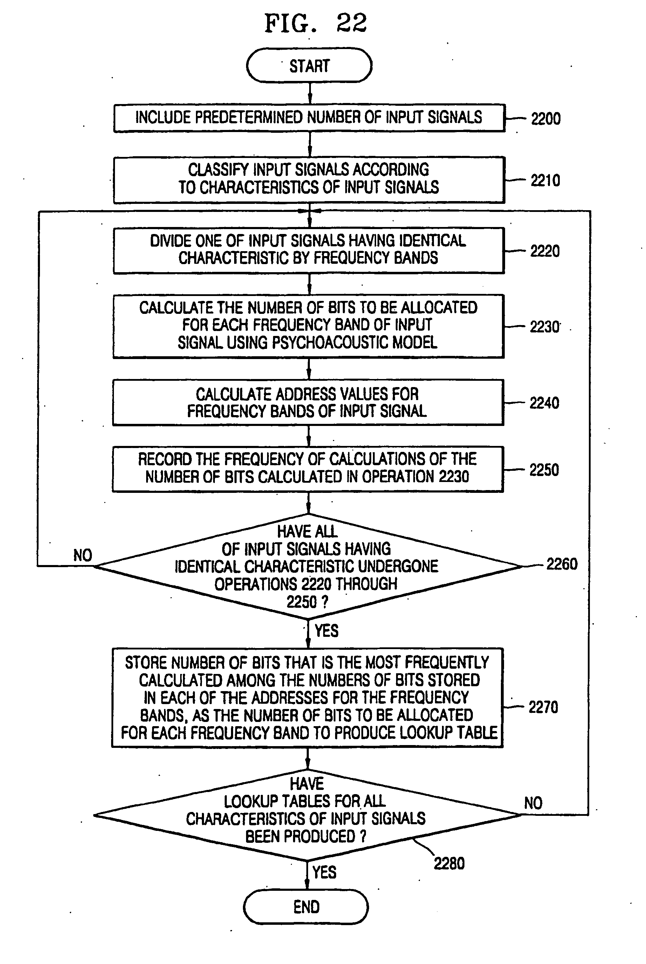

FIG. 22 is a flowchart illustrating a method of producing a plurality of lookup tables. Referring to FIG. 22, a predetermined number of input signals having various characteristics are included in operation 2200. The input signals are classified according to the characteristics of the input signals, in operation 2210. The characteristics of the input signals are the same as in the description of the lookup tables. Operations 2220 through 2280 of FIG. 22 are the same as operation 2110 through 2170 of FIG. 21.

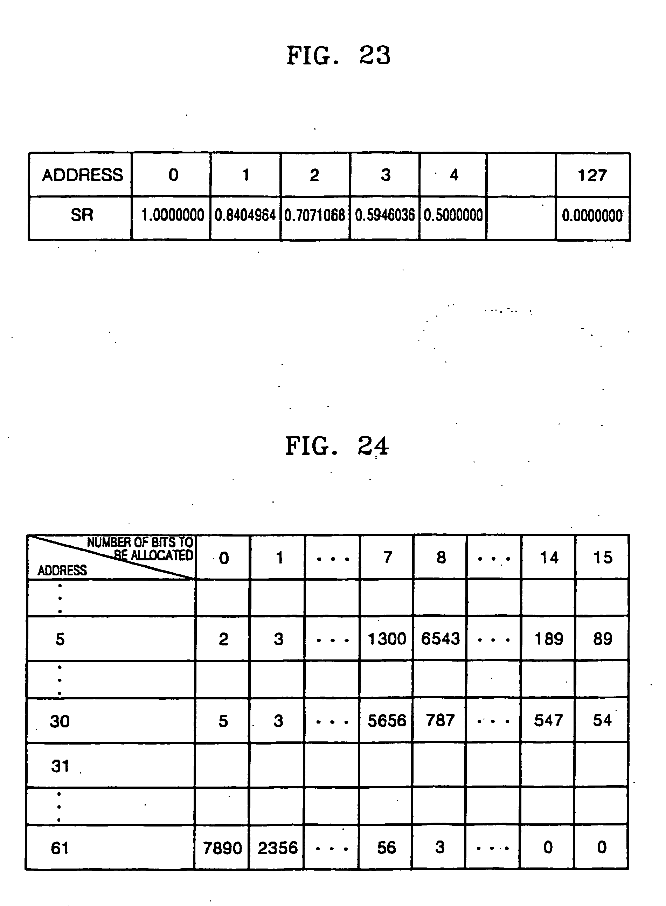

FIG. 23 is a table illustrating a method of setting addresses used in a lookup table. Referring to FIG. 23, a larger value between an occupancy rate of a squared scale factor of each frequency band and an occupancy rate of a mean power of each frequency band is used as each address of a lookup table. The occupancy rates used as the addresses of the lookup table range between 0 and 1. The occupancy rates between 0 and 1 are divided into 127 addresses.

FIG. 24 is a table illustrating a method of producing a lookup table. The method of FIG. 24 is operation 2160 of FIG. 21 or operation 2270 of FIG. 22, in which a lookup table is produced using the frequency of calculations of the stored number of bits allocated for each frequency band. Referring to FIG. 24, the number of bits allocated for each address for each frequency band is stored to produce a lookup table. In address 5 of the lookup table, the number of allocated bits, 8, which was calculated the most frequently among the stored numbers of allocated bits for the address 5, is stored as a final number of bits to be allocated. In address 30 of the lookup table, the number of allocated bits, 7, which was calculated the most frequently among the stored numbers of allocated bits for the address 30, is stored as a final number of bits to be allocated. In address 61 of the lookup table, the number of allocated bits, 0, which was calculated the most frequently among the stored numbers of allocated bits for the address 61, is stored as a final number of bits to be allocated. To reduce a volume of the lookup table, addresses which record 0 as the number of bits allocated may be excluded from a lookup table to be produced. Also, when identical numbers of allocated bits are recorded in consecutive addresses, only addresses that record different numbers of allocated bits may be stored in the lookup table.

Decoding apparatuses corresponding to the encoding apparatuses according to the four embodiments of the present invention will now be described.

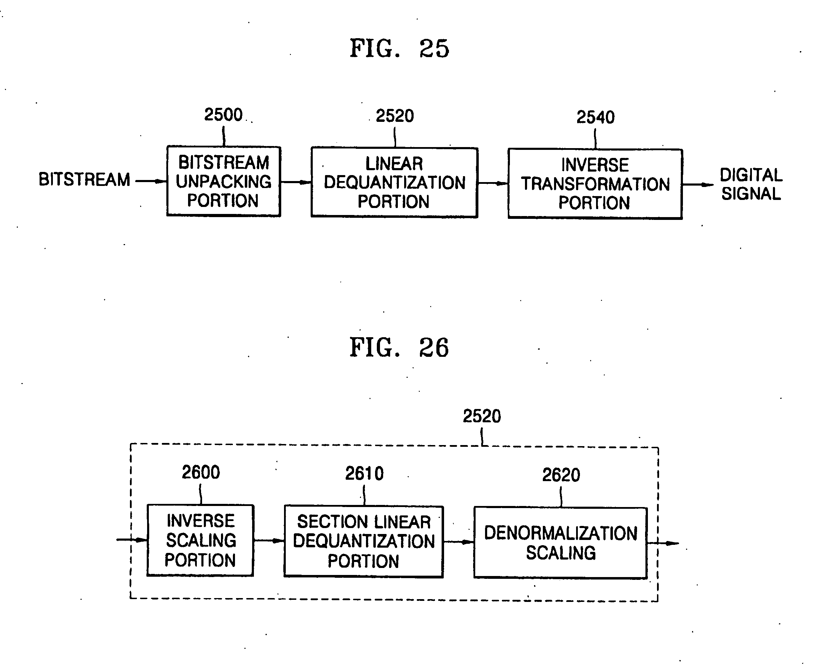

FIG. 25 is a block diagram of a digital signal decoding apparatus corresponding to the digital signal encoding apparatus in which linear quantization by sections is performed using a plurality of lookup tables. This digital signal decoding apparatus is comprised of a bitstream unpacking portion 2500, a linear dequantization portion 2520, and an inverse transformation portion 2540.

The bitstream unpacking portion 2500 extracts linearly quantized data and side information from a bitstream into which a digital signal is encoded. For example, when the bitstream is an audio signal bitstream, quantized sample data and side information are extracted.

The linear dequantization portion 2520 dequantizes the linearly quantized data on a section-by-section basis using the side information extracted by the bitstream unpacking portion 2500. The section corresponds to a section set upon quantization for encoding. If the section for quantization is set based on an input axis of the graph of FIG. 11 upon encoding, the section for dequantization is set based on an output axis of the graph of FIG. 11 upon decoding.

The inverse transformation portion 2540 inversely transforms the dequantized data obtained by the linear dequantization portion 2520 into the digital signal, preferably, PCM data. The inverse transformation is an inverse transformation of the transformation used upon encoding. When a band-split filter is used as a sub-band filter upon transformation, the inverse transformation portion 2540 uses a band-synthesis filter.

FIG. 26 is a block diagram of a detailed structure of the linear dequantization portion 2520. The linear dequantization portion 2520 is comprised of an inverse scaling portion 2600, a section linear dequantization portion 2610, and a denormalization portion 2620.

The inverse scaling portion 2600 inverse scales the sample data that are linearly quantized in sections, using bit allocation information included in the side information extracted by the bitstream unpacking portion 2500. The inverse scaling corresponds to the scaling used for quantization. For example, if 4 bits are allocated for encoding and the sample data was multiplied by 15, then the sample data is divided by 15 for decoding.

The section linear dequantization portion 2610 linear dequantizes the inverse-scaled data for each section. The denormalization portion 2620 denormalizes the data dequantized by the section linear dequantization portion 2610 using an inverse scale factor that corresponds to the scaling factor used for quantization.

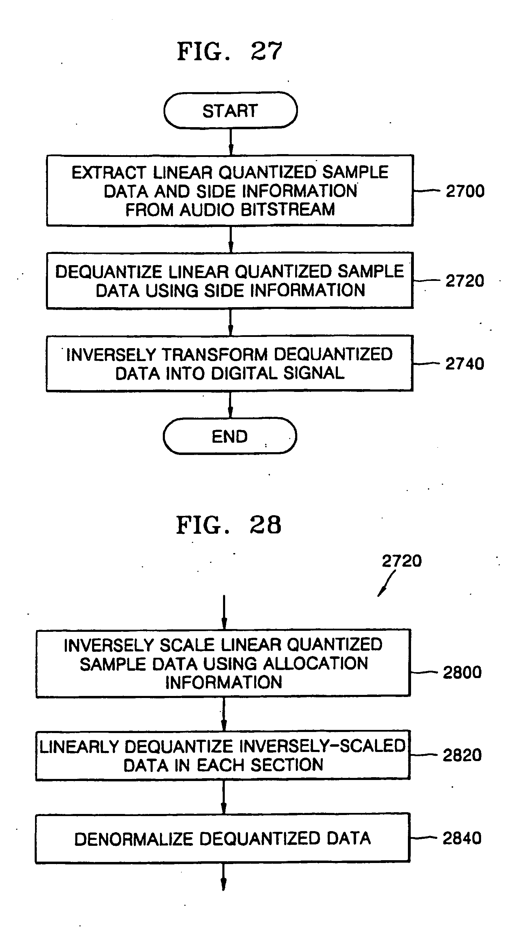

FIG. 27 is a flowchart illustrating a digital signal decoding method corresponding to the digital signal encoding method in which linear quantization by sections is performed using a plurality of lookup tables, according to an embodiment of the present invention. Referring to FIGS. 25 and 27, first, when a bit stream of a digital signal, which may be an audio digital signal, is input to the bitstream unpacking portion 2500, quantized sample data and side information are extracted from the audio bitstream, in operation 2700.

In operation 2720, the sample data that is linearly quantized by sections, is dequantized by sections using the side information by the linear dequantization portion 2520. The sections for dequantization correspond to the sections divided for the linear quantization (e.g., if the sections for quantization were divided with respect to the input-axis illustrated in FIG. 11 for encoding, then the sections are divided with respect to the output-axis for decoding). Afterwards, the dequantized data is inversely transformed into the digital signal, preferably PCM data, in operation 2740. This inverse transformation is the inverse of the transformation used for encoding.

FIG. 28 is a flowchart illustrating operation 2720 of dequantizing the sample data. Referring to FIGS. 25 and 28, the sample data that are linearly quantized by sections is scaled inversely to the scaling used for quantization by the inverse scaling portion 2600 using the bit allocation information, in operation 2800. Afterwards, the inversely scaled data is linearly dequantized in each section in the section linear dequantization portion 2610, in operation 2820. The dequantized data is then denormalized by the denormalization portion 2620 by using an inverse scale factor that corresponds to the scaling factor used for quantization, in operation 2840.

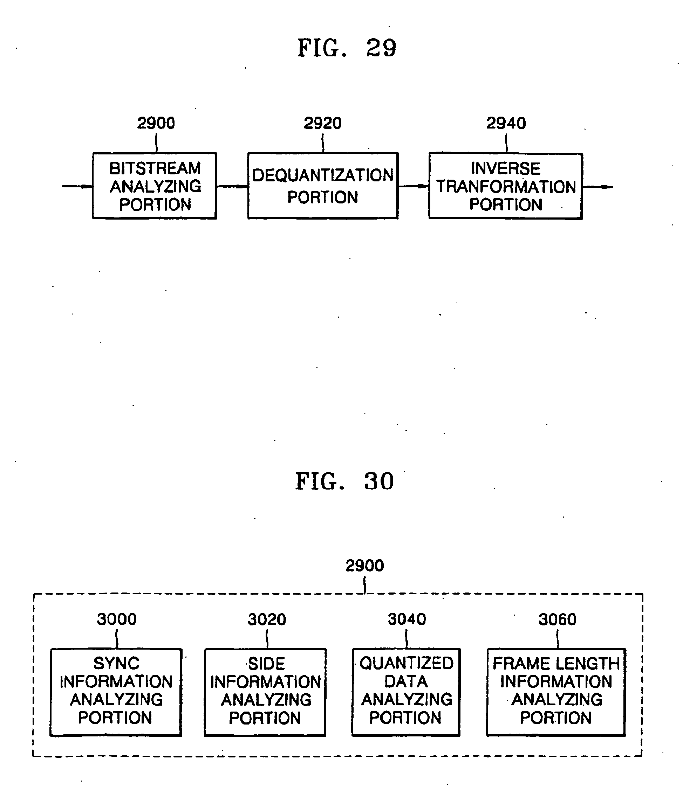

FIG. 29 is a block diagram of a digital signal decoding apparatus corresponding to the digital signal encoding apparatus in which a bit stream including frame length information is produced using a plurality of lookup tables, according to another embodiment of the present invention. This digital signal decoding apparatus is comprised of a bitstream analyzing portion 2900, a dequantization portion 2920, and an inverse transformation portion 2940. The bitstream analyzing portion 2900 extracts side information, quantized data, and frame length information from a bitstream of a digital signal. If the bitstream is an audio signal bitstream, quantized sample data, side information, and frame length information are extracted. The bitstream analyzing portion 2900 also extracts sync information if the bitstream further includes sync information.

FIG. 30 is a block diagram of the bit stream analyzing portion 2900, which is comprised of a synch information analyzing portion 3000, a side information analyzing portion 3020, a quantized data analyzing portion 3040, and a frame length information analyzing portion 3060.

The synch information analyzing portion 3000 extracts the sync information from the bitstream of the digital signal. The side information analyzing portion 3020 extracts the side information from the bitstream. The quantized data analyzing portion 3040 extracts the quantized data from the bitstream. The frame length information analyzing portion 3060 extracts the frame length information from the bitstream.

Referring back to FIG. 29, the dequantization portion 2920 dequantizes the extracted quantized data using the side information extracted by the bitstream analyzing portion 2900.

The inverse transformation portion 2940 transforms the data dequantized by the dequantization portion 2920 into the digital signal, preferably, PCM data, using an inverse transformation of a transformation used for encoding. If a band-split filter was used as a sub-band filter upon transformation, a band-synthesis filter is used as the inverse transformation portion 2940.

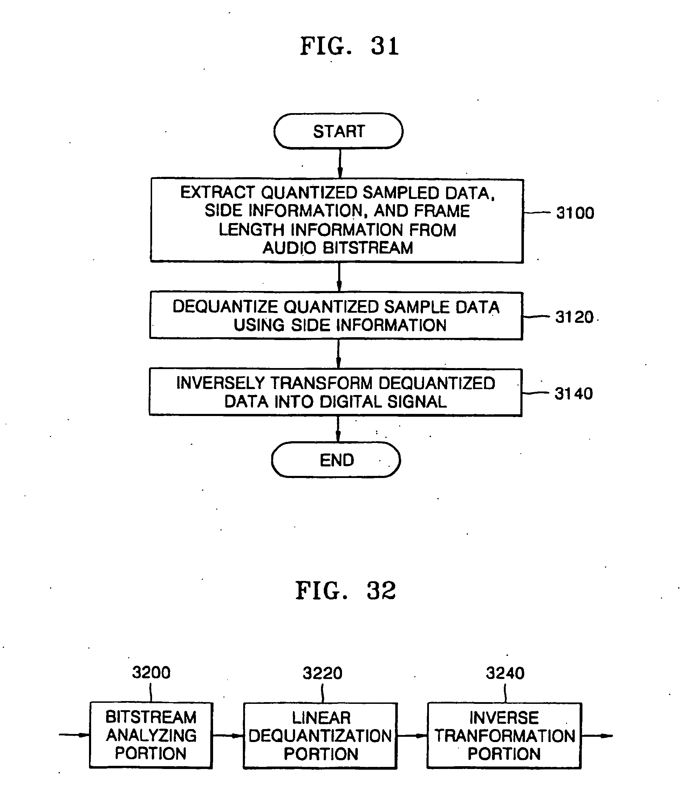

FIG. 31 is a flowchart illustrating a digital signal decoding method corresponding to the digital signal encoding method in which a bit stream including frame length information is produced using a plurality of lookup tables.

Referring to FIGS. 29 and 31, first, when a bitstream, which may be an audio bitstream, of a digital signal is input to the bitstream analyzing portion 2900, quantized sampled data, side information, and frame length information are extracted from the audio bitstream, in operation 3100. If sync information is included in the bitstream, it is also extracted from the bitstream.

In operation 3120, the dequantization portion 2920 dequantizes the quantized sample data using the side information. Thereafter, in operation 3140, the dequantized data is transformed inversely to the transformation used for encoding to produce the digital signal, which may be PCM data.

FIG. 32 is a block diagram of a digital signal decoding apparatus corresponding to a digital signal encoding apparatus in which a bit stream including frame length information is produced using a plurality of lookup tables and linear quantization by sections and to a digital signal encoding apparatus in which a bit stream including frame length information is produced using linear quantization by sections. This digital signal decoding apparatus is comprised of a bitstream analyzing portion 3200, a linear dequantization portion 3220, and an inverse transformation portion 3240.

The bitstream analyzing portion 3200 extracts side information, quantized data, and frame length information from a bitstream of a digital signal. If the bitstream is an audio signal bitstream, quantized sample data, side information, and frame length information are extracted. The bitstream analyzing portion 3200 also extracts sync information if the bitstream further includes the sync information.

The bit stream analyzing portion 3200 has the same structure as that of the bitstream analyzing portion 2900 illustrated in FIG. 30. Accordingly, the bit stream analyzing portion 3200 is comprised of the synch information analyzing portion 3000, the side information analyzing portion 3020, the quantized data analyzing portion 3040, and the frame length information analyzing portion 3060. The synch information analyzing portion 3000 extracts the sync information from the bitstream of the digital signal. The side information analyzing portion 3020 extracts the side information from the bitstream. The quantized data analyzing portion 3040 extracts the quantized data from the bitstream. The frame length information analyzing portion 3060 extracts the frame length information from the bitstream.

The linear dequantization portion 3220 dequantizes the data which is linearly quantized by sections, by sections corresponding to the sections divided for the linear quantization, using the side information extracted by the bitstream analyzing portion 3200. If the sections for the linear quantization are set based on the input axis of the graph of FIG 11 upon encoding, the sections for the linear dequantization are set based on the output axis of the graph of FIG. 11 upon decoding.

The linear dequantization portion 3220 has the same structure as the structure of the linear dequantization portion 2520 illustrated in FIG. 26. Accordingly, the linear dequantization portion 3220 is comprised of the inverse scaling portion 2600, the section linear dequantization portion 2610, and the denormalization portion 2620. The inverse scaling portion 2600 inversely scales the sample data that are linearly quantized in sections, using bit allocation information included in the side information extracted by the bitstream unpacking portion 2500. The inverse scaling corresponds to the scaling used for quantization. For example, if 4 bits are allocated for encoding and the sample data was multiplied by 15, then the sample data is divided by 15 for decoding.

The section linear dequantization portion 2610 linear dequantizes the inverse-scaled data for each section. The denormalization portion 2620 denormalizes the data dequantized by the section linear dequantization portion 2610 using an inverse scale factor that corresponds to the scaling factor used for quantization.

Referring back to FIG. 32, the inverse transformation portion 3240 transforms the data dequantized by the linear dequantization portion 3220 into the digital signal, preferably, PCM data, using an inverse transformation of a transformation used for encoding. If a band-split filter was used as a sub-band filter upon transformation, a band-synthesis filter is used as the inverse transformation portion 3240.

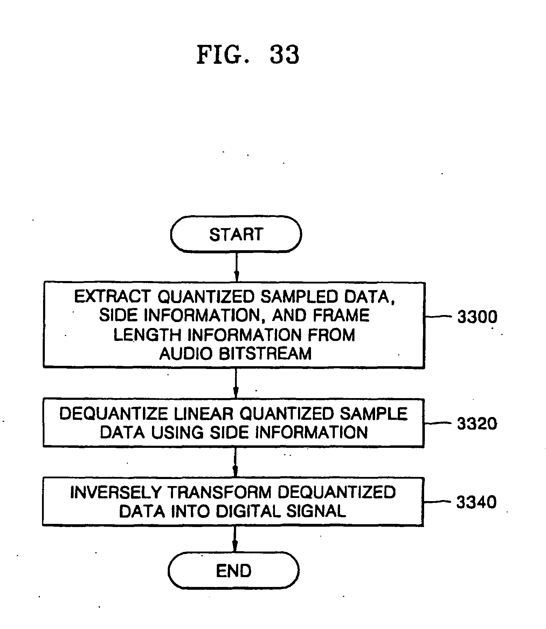

FIG. 33 is a flowchart illustrating a digital signal decoding method corresponding to the digital signal encoding method in which a bit stream including frame length information is produced using a plurality of lookup tables and linear quantization by sections and to a digital signal encoding method in which a bit stream including frame length information is produced using linear quantization by sections.

Referring to FIGS. 32 and 33, first, when a bitstream, which may be an audio bitstream, of a digital signal is input to the bitstream analyzing portion 3200, side information, quantized sampled data, and frame length information are extracted from the audio bitstream by the side information analyzing portion 3020, the quantized data analyzing portion 3040, and the frame length information analyzing portion 3060 of the bitstream analyzing portion 3200, respectively, in operation 3300. If sync information is included in the bitstream, it is also extracted from the bitstream by the sync information analyzing portion 3000 of the bitstream analyzing portion 3200.

In operation 3320, the sample data that is linearly quantized by sections is dequantized by sections using the side information by the linear dequantization portion 3220. The sections for dequantization correspond to the sections divided for the linear quantization (e.g., if the sections for quantization were divided with respect to the input-axis illustrated in FIG. 11 for encoding, then the sections are divided with respect to the output-axis for decoding). Afterwards, the dequantized data is inversely transformed into the digital signal, preferably PCM data, in operation 3340. This inverse transformation is the inverse of the transformation used for encoding.

Operation 3320 of FIG. 33 is the same as operation 2720, so it is comprised of operations 2800, 2820, and 2840 illustrated in FIG. 28. Referring to FIG. 28, first, the sample data that are linearly quantized by sections is scaled inversely to the scaling used for quantization by the inverse scaling portion 2600 using the bit allocation information, in operation 2800. Afterwards, the inversely scaled data is linearly dequantized in each section in the section linear dequantization portion 2610, in operation 2820. The dequantized data is then denormalized by the denormalization portion 2620 by using an inverse scale factor that corresponds to the scaling factor used for quantization, in operation 2840.

According to embodiments of the the present invention as described above, a digital signal is encoded using a plurality of lookup tables. In other words, the numbers of bits allocated for frequency bands are extracted from an optimal lookup table selected from the lookup tables according to characteristics of an input signal. Thus, control of the amount of bits adequate for the characteristics of the input signal is possible. Also, an additional calculation can be saved by using occupancy rates of the frequency bands, which are the same as addresses of each lookup table, as a characteristic of the input signal.

In addition, by encoding a digital signal using linear quantization by sections, the complexity of a non-linear quantizer can be significantly reduced while improving a sound quality compared to a general linear quantizer in consideration of a distribution of audio data.

Furthermore, when frame length information is included in the end of the frame comprised of frames, a point of effective audio data to be reproduced upon generation of an impact can be accurately searched for. Therefore, a period of time when reproduction of audio data is protected from the impact can be extended due to the encoding according to an embodiment of the present invention, and a clean sound without interruptions can be provided to users within the protection-from-impact period of time regardless of an encoding rate.

Embodiments of the present invention can be embodied as computer (including all devices that have information processing functions) readable codes in a computer storage such as a computer readable recording medium. The computer readable recording medium is any data storage device that can store data which can be thereafter read by a computer system. Examples of the computer readable recording medium include read-only memory (ROM), random-access memory (RAM), CD-ROMs, magnetic tapes, floppy disks, and optical data storage devices.

Although a few embodiments of the present invention have been shown and described, it would be appreciated by those skilled in the art that changes may be made in these embodiments without departing from the principles of the invention, the scope of which is defined in the claims.

**Claims**

1. A method of encoding a digital audio signal, comprising:

transforming (500) a digital input signal into samples so that redundant information among signals can be removed;

obtaining (520,540) a number of bits to be allocated for each of a plurality of quantization units;

quantizing (560) the samples using the number of bits allocated for each quantization unit; and

producing (580) a bitstream comprising the quantized samples and predetermined side information semicolor;

**characterised in that** obtaining a number of bits to be allocated comprises selecting (520) a lookup table corresponding to a characteristic of the digital input signal among a plurality of lookup tables that indicate different numbers of bits allocated for each of a plurality of quantization units depending on different characteristics of input signals and acquiring (540) the number of bits allocated for each quantization unit from the selected lookup table.

2. A method as claimed in claim 1, wherein quantizing the samples using the number of bits allocated for each quantization unit comprises dividing a distribution of samples within each quantization unit into a predetermined number of sections and linearly quantizing (560) the samples using the allocated number of bits on a section-by-section basis.

3. A method as claimed in claim 2, wherein producing a bitstream comprises producing a bitstream from the linearly quantized samples and the predetermined side information.

4. A method as claimed in any preceding claim, wherein producing a bitstream from the quantized samples and predetermined side information is such that information about a frame length is stored in the end of the frame.

5. The method of any preceding claims, wherein the transformation of the digital signal is performed using one of a modified discrete cosine transform, a fast Fourier transform, a discrete cosine transform, and a sub-band filtering.

6. The method of any preceding claim, wherein the side information includes at least a scale factor of each quantization unit and a number of bits to be allocated for each quantization unit.

7. The method of any of claims 1 to 6, wherein the characteristic of the digital input signal in the selecting of the lookup table and acquiring of the number of bits allocated is the number of frequency bands including samples at occupancy rates no less than or no greater than a predetermined reference value among frequency bands of the digital input signal.

8. The method of claim 7, wherein the occupancy rate comprises one of a larger occupancy rate between an occupancy rate of a squared scale factor of a frequency band and an occupancy rate of a mean power of samples within the frequency band and a larger occupancy rate between an occupancy rate of a scale factor of a frequency band and an occupancy rate of a mean value of samples within the frequency band.

9. The method of any of claims 1 to 8, wherein each of the lookup tables includes at least one address for each quantization unit and a predetermined number of bits for each quantization unit.

10. The method of claim 9, wherein the addresses of each of the lookup tables comprise one of scale factors and squared scale factors of the frequency bands.

11. The method of claim 9 or 10, wherein the addresses of each of the lookup tables comprise one of mean values and mean powers of samples within the frequency bands.

12. The method of claim 9, 10 or 11, wherein the addresses of each of the lookup tables comprise one of larger occupancy rates between occupancy rates of scale factors of the frequency bands and occupancy rates of mean values of samples within the frequency bands and larger occupancy rates between occupancy rates of squared scale factors of the frequency bands and occupancy rates of mean powers of samples within the frequency bands.

13. The method of any of claims 1 to 12, further comprising, after the selecting of the lookup table and acquiring of the number of bits allocated, comparing the number of bits allocated for the entire digital input signal with the number of bits required for the entire digital input signal and adjusting the number of bits allocated for the entire digital input signal according to a result of the comparison.

14. The method of any of claims 2 to 13 when dependent on claim 2, wherein the dividing of the distribution of the samples and linearly quantizing of the samples comprises:

normalizing the samples within each quantization unit using a predetermined scale factor;
dividing a range of normalized sample values into a predetermined number of sections and transforming the normalized sample values by applying a linear function set for each section;
scaling the transformed values using the number of bits allocated for each quantization unit; and
rounding the scaled values to a nearest whole number to obtain quantized values.

15. The method of claim 14, wherein the scale factor is an integer determined by a predetermined function of a value no less than a maximum absolute value among sample values within each quantizing unit.

16. The method of claim 14 or 15, wherein the linear functions comprise a plurality of independent linear functions for the sections.

17. The method of claim 16, wherein the dividing of the range of the normalized sample values and transforming of the normalized sample values comprises:

dividing the range of the normalized sample values into two sections; and
transforming the normalized data by applying linear functions set for the two sections to the normalized data,

wherein the linear functions are expressed as $y = \dfrac{ax}{(a-2b)}$ and $y = \dfrac{x}{(1+2b)} + \dfrac{2b}{(1+2b)}$, wherein $a$ denotes the range of normalized values, and $b$ denotes section displacement from the center of $a$.

18. The method of any of claims 14 to 17, wherein the linear quantization by sections satisfies continuity.

19. The method of any of claims 4 to 18 when dependent on claim 4,
wherein the bitstream comprised of frames further includes sync information indicating a beginning of each frame, which is located in a head portion of each frame.

20. The method of claim 19, wherein the bitstream comprised of frames is a result of encoding at a fixed bit rate or a variable bit rate.

21. The method of any of claims 4 to 20 when dependent on claim 4,
wherein the bitstream comprised of frames is a result of encoding at a fixed bit rate or a variable bit rate.

22. An apparatus for encoding a digital audio signal, comprising:

a data transformation portion (300, 1700, 1900) arranged to transform a digital input signal into samples so that redundant information among signals can be removed;
a number-of-bits-to-be-allocated obtaining portion (310,320,330,340,350) including a lookup table (320,1920) arranged to obtain the number of bits to be allocated for each of a plurality of quantization units;
a quantization portion (360,1720,1960) for quantizing the samples using the number of bits allocated for each quantization unit by the number-of-bits-to-be-allocated obtaining portion; and
a bitstream producing portion (370,1730,1970) arranged to produce a bitstream comprising the quantized samples and predetermined side information;

**characterised in that** the number-of-bits-to-be-allocated obtaining portion comprises:

a plurality of lookup tables (320,330,340) arranged to indicate different numbers of bits allocated for each of a plurality of quantization units depending on different characteristics of input signals;
a lookup table selection portion (310,1910) arranged to select a lookup table corresponding to a characteristic of the digital input signal among the lookup tables; and
a bit allocation portion (350,1950) arranged to extract the numbers of bits allocated for the quantization units from addresses for the quantization units in the selected lookup table number-of-bits-to-be-allocated.

23. An apparatus as claimed in claim 22, wherein the quantization portion (360,1720,1960) comprises a linear quantization portion arranged to divide a distribution of samples within each quantization unit into a predetermined number of sections and to linearly quantize the samples using the allocated number of bits on a section-by-section basis.

**24.** An apparatus as claimed in claim 23, wherein the bitstream producing portion (370,1730,1970) comprises a bit packing portion arranged to produce a bitstream from the linearly quantized samples and predetermined side information.

**25.** An apparatus as claimed in any one of claims 22 to 24, wherein the bitstream producing portion (370,1730,1970) is arranged to produce a bitstream comprised of frames from the linearly quantized samples and predetermined side information so that information about a frame length is included in the end of the frame.

**26.** The apparatus of any of claims 22 to 25, wherein the characteristic of the input signal in the selecting of the lookup table and acquiring of the number of bits allocated is the number of frequency bands including samples at occupancy rates no less than or no greater than a predetermined reference value among frequency bands of the input signal.

**27.** The apparatus of claim 26, wherein the occupancy rate is one of a larger occupancy rate between an occupancy rate of a squared scale factor of a frequency band and an occupancy rate of a mean power of samples within the frequency band and a larger occupancy rate between an occupancy rate of a scale factor of a frequency band and an occupancy rate of a mean value of samples within the frequency band.

**28.** The apparatus of any of claims 22 to 27, wherein the addresses of each of the lookup tables (320,330,340,1920,1930,1940) are one of scale factors and squared scale factors of the frequency bands.

**29.** The apparatus of any of claims 22 to 28
wherein the addresses of each of the lookup tables (320,330,340, 1920,1930,1940) are one of mean values and mean powers of samples within the frequency bands.

**30.** The apparatus of any of claims 22 to 29, wherein the addresses of each of the lookup tables (320,330,340,1920,1930,1940) are one of large occupancy rates between occupancy rates of scale factors of the frequency bands and occupancy rates of mean values of samples within the frequency bands and larger occupancy rates between occupancy rates of squared scale factors of the frequency bands and occupancy rates of mean powers of samples within the frequency bands.

**31.** The apparatus of any of claims 22 to 30, further comprising a number-of-bits adjusting portion comparing the number of bits allocated for the entire input signal by the bit allocation portion with the number of bits required for the entire input signal and adjusting the number of bits allocated for the entire input signal according to a result of the comparison.

**32.** The apparatus of any of claims 23 to 31 when dependent on claim 23, wherein the linear quantization portion comprises:

a data normalization portion (400) arranged to normalize the samples obtained by the data transformation portion using a predetermined scale factor;
a section quantization portion (420) arranged to divide a range of normalized sample values into a predetermined number of sections and to apply a linear function set for each section to the normalized sample values;
a scaling portion (440) arranged to scale the values obtained by the section quantization portion using the number of bits allocated for each quantization unit by the bit allocation portion; and
a rounding portion (460) arranged to round the scaled values to the nearest whole number using the number of allocated bits to obtain quantized values.

**33.** The apparatus of claim 32, wherein the linear functions are a plurality of independent linear functions for the sections.

**34.** The apparatus of any of claims 25 to 33 when dependent on claim 25, wherein the bitstream comprised of frames further includes sync information indicating a beginning of each frame, which is located in a head portion of each frame.

**35.** A computer program comprising computer program code means adapted to perform all the steps of any of claims 1 to 21 when said program is run on a computer.

**36.** A computer program as claimed in claim 35 embodied on a computer readable medium.

**EP 1 600 946 B1**

**Patentansprüche**

1. Verfahren zur Kodierung eines digitalen Audiosignals, umfassend:

   Transformieren (500) eines digitalen Eingabesignals in Abtastungen, so dass redundante Informationen in Signalen entfernt werden können,
   Ermitteln (520, 540) einer Anzahl an Bits, die jeder einer Mehrzahl von Quantisierungseinheiten zuzuweisen sind,
   Quantisieren (560) der Abtastungen unter Verwendung der jeder Quantisierungseinheit zugewiesenen Anzahl an Bits und
   Erzeugen (580) eines Bitstroms, der die quantisierten Abtastungen und vorgegebene Nebeninformationen umfasst, **dadurch gekennzeichnet, dass** das Ermitteln einer zuzuweisenden Anzahl an Bits umfasst: Auswählen (520) einer Nachschlagetabelle, die einer Charakteristik des digitalen Eingabesignals entspricht, aus einer Mehrzahl von Nachschlagetabellen, die unterschiedliche Anzahlen an Bits angeben, die jeder einer Mehrzahl von Quantisierungseinheiten zugewiesen sind, in Abhängigkeit von unterschiedlichen Charakteristiken von Eingabesignalen und Erfassen (540) der Anzahl an Bits, die jeder Quantisierungseinheit zugewiesen sind, aus der ausgewählten Nachschlagetabelle.

2. Verfahren nach Anspruch 1, wobei das Quantisieren der Abtastungen unter Verwendung der jeder Quantisierungseinheit zugewiesenen Anzahl an Bits ein Unterteilen einer Verteilung von Abtastungen in jeder Quantisierungseinheit in eine vorgegebene Anzahl an Abschnitten und ein lineares Quantisieren (560) der Abtastungen unter Verwendung der zugewiesenen Anzahl an Bits auf Basis einzelner Abschnitte umfasst.

3. Verfahren nach Anspruch 2, wobei das Erzeugen eines Bitstroms ein Erzeugen eines Bitstroms aus den linear quantisierten Abtastungen und den vorgegebenen Nebeninformationen umfasst.

4. Verfahren nach einem der vorhergehenden Ansprüche, wobei das Erzeugen eines Bitstroms aus den quantisierten Abtastungen und den vorgegebenen Nebeninformationen derart erfolgt, dass Informationen über eine Rahmenlänge am Ende des Rahmens gespeichert werden.

5. Verfahren nach einem der vorhergehenden Ansprüche, wobei die Transformation des digitalen Signals unter Verwendung einer modifizierten diskreten Cosinustransformation, einer schnellen Fourier-Transformation, einer diskreten Cosinustransformation oder einer Unterbandfilterung durchgeführt wird.

6. Verfahren nach einem der vorhergehenden Ansprüche, wobei die Nebeninformationen mindestens einen Skalenfaktor jeder Quantisierungseinheit und eine Anzahl an Bits, die jeder Quantisierungseinheit zuzuweisen sind, beinhalten.

7. Verfahren nach einem der Ansprüche 1 bis 6, wobei die Charakteristik des digitalen Eingabesignals beim Auswählen der Nachschlagetabelle und Erfassen der zugewiesenen Anzahl an Bits die Anzahl an Frequenzbändern ist, die Abtastungen mit Besetzungsraten von nicht weniger als oder nicht mehr als einem vorgegebenen Referenzwert unter den Frequenzbändern des digitalen Eingabesignals beinhaltet.

8. Verfahren nach Anspruch 7, wobei die Besetzungsrate eine höhere Besetzungsrate zwischen einer Besetzungsrate eines quadrierten Skalenfaktors eines Frequenzbands und einer Besetzungsrate eines Potenzmittelwerts von Abtastungen im Frequenzband oder eine höhere Besetzungsrate zwischen einer Besetzungsrate eines Skalenfaktors eines Frequenzbands und einer Besetzungsrate eines Mittelwerts von Abtastungen in dem Frequenzband umfasst.

9. Verfahren nach einem der Ansprüche 1 bis 8, wobei jede der Nachschlagetabellen mindestens eine Adresse für jede Quantisierungseinheit und eine vorgegebene Anzahl an Bits für jede Quantisierungseinheit beinhaltet.

10. Verfahren nach Anspruch 9, wobei die Adressen jeder der Nachschlagetabellen Skalenfaktoren oder quadrierte Skalenfaktoren der Frequenzbänder umfassen.

11. Verfahren nach Anspruch 9 oder 10, wobei die Adressen jeder der Nachschlagetabellen Mittelwerte oder Potenzmittelwerte von Abtastungen in den Frequenzbändern umfassen.

12. Verfahren nach Anspruch 9, 10 oder 11, wobei die Adressen jeder der Nachschlagetabellen höhere Besetzungsraten zwischen Besetzungsraten von Skalenfaktoren der Frequenzbänder und Besetzungsraten von Mittelwerten von Abtastungen in den Frequenzbändern oder höhere Besetzungsraten zwischen Besetzungsraten von quadrierten Skalenfaktoren der Frequenzbänder und Besetzungsraten von Potenzmittelwerten von Abtastungen in den Frequenzbändern umfassen.

13. Verfahren nach einem der Ansprüche 1 bis 12, weiter umfassend, nach dem Auswählen der Nachschlagetabelle und Erfassen der zugewiesenen Anzahl an Bits, Vergleichen der Anzahl an Bits, die dem gesamten digitalen Eingabesignal zugewiesen sind, mit der Anzahl an Bits, die für das gesamte digitale Eingabesignal erforderlich sind, und Einstellen der Anzahl an Bits, die für das gesamte digitale Eingabesignal zugewiesen sind, gemäß einem Vergleichsergebnis.

14. Verfahren nach einem der Ansprüche 2 bis 13, wenn von Anspruch 2 abhängig, wobei das Unterteilen der Verteilung von Abtastungen und das lineare Quantisieren der Abtastungen umfasst:

Normalisieren der Abtastungen in jeder Quantisierungseinheit unter Verwendung eines vorgegebenen Skalenfaktors,
Unterteilen eines Bereichs von normalisierten Abtastwerten in eine vorgegebene Anzahl an Abschnitten und Transformieren der normalisierten Abtastwerte durch Anwenden einer linearen Funktion, die für jeden Abschnitt gesetzt ist,
Skalieren der transformierten Werte unter Verwendung der Anzahl an Bits, die für jede Quantisierungseinheit zugewiesen sind, und
Runden der skalierten Werte auf die nächstgelegene ganze Zahl, um quantisierte Werte zu erhalten.

15. Verfahren nach Anspruch 14, wobei der Skalenfaktor eine ganze Zahl ist, die durch eine vorgegebene Funktion eines Wertes von nicht weniger als einem maximalen Absolutwert unter den Abtastwerten in jeder Quantisierungseinheit bestimmt wird.

16. Verfahren nach Anspruch 14 oder 15, wobei die linearen Funktionen eine Mehrzahl von unabhängigen linearen Funktionen für die Abschnitte umfassen.

17. Verfahren nach Anspruch 16, wobei das Unterteilen des Bereichs der normalisierten Abtastwerte und das Transformieren der normalisierten Abtastwerte umfasst:

Unterteilen des Bereichs der normalisierten Abtastwerte in zwei Abschnitte und
Transformieren der normalisierten Daten durch Anwenden von linearen Funktionen, die für die beiden Abschnitte gesetzt sind, auf die normalisierten Daten,

wobei die linearen Funktionen ausgedrückt sind als

$$y = \frac{ax}{(a-2b)} \text{ und } y = \frac{x}{(1+2b)} + \frac{2b}{(1+2b)},$$

worin a den Bereich von normalisierten Werten bezeichnet und b eine Abschnittsverschiebung vom Mittelpunkt von a bezeichnet.

18. Verfahren nach einem der Ansprüche 14 bis 17, wobei die abschnittweise lineare Quantisierung eine Stetigkeitsbedingung erfüllt.

19. Verfahren nach einem der Ansprüche 4 bis 18, wenn von Anspruch 4 abhängig, wobei der aus Rahmen gebildete Bitstrom weiter Synchronisationsinformationen beinhaltet, die einen Beginn jedes Rahmens angeben und die in einem Kopfteil jedes Rahmens gelegen sind.

20. Verfahren nach Anspruch 19, wobei der aus Rahmen gebildete Bitstrom das Ergebnis einer Kodierung bei einer festen Bitrate oder einer variablen Bitrate ist.

21. Verfahren nach einem der Ansprüche 4 bis 20, wenn von Anspruch 4 abhängig, wobei der aus Rahmen gebildete Bitstrom das Ergebnis einer Kodierung bei einer festen Bitrate oder einer variablen Bitrate ist.

22. Vorrichtung zum Kodieren eines digitalen Audiosignals, umfassend:

einen Datentransformationsteil (300, 1700, 1900), der dazu ausgebildet ist, ein digitales Eingabesignal so in Abtastungen zu transformieren, dass redundante Informationen in Signalen entfernt werden können,
einen Ermittlungsteil (310, 320, 330, 340, 350) für eine zuzuweisende Anzahl an Bits, der eine Nachschlagetabelle (320, 1920) beinhaltet, die dazu ausgebildet ist, die Anzahl an zuzuweisenden Bits für jede einer Mehrzahl von Quantisierungseinheiten zu ermitteln,
einen Quantisierungsteil (360, 1720, 1960) zum Quantisieren der Abtastungen unter Verwendung der jeder Quantisierungseinheit vom Ermittlungsteil für eine zuzuweisende Anzahl an Bits zugewiesenen Anzahl an Bits und
einen Bitstromerzeugungsteil (370, 1730, 1970), der dazu ausgebildet ist, einen Bitstrom, der die quantisierten Abtastungen und vorgegebene Nebeninformationen umfasst, zu erzeugen,

**dadurch gekennzeichnet, dass** der Ermittlungsteil für eine zuzuweisende Anzahl an Bits umfasst:

eine Mehrzahl von Nachschlagetabellen (320, 330, 340), die dazu ausgebildet sind, unterschiedliche Anzahlen an Bits, die jeder einer Mehrzahl von Quantisierungseinheiten zugewiesen sind, in Abhängigkeit von unterschiedlichen Charakteristiken von Eingabesignalen anzugeben,
einen Nachschlagetabellenauswahlteil (310, 1910), der dazu ausgebildet ist, eine Nachschlagetabelle, die einer Charakteristik des digitalen Eingabesignals entspricht, aus den Nachschlagetabellen auszuwählen,
einen Bitzuweisungsteil (350, 1950), der dazu ausgebildet ist, die Anzahlen an Bits, die den Quantisierungseinheiten zugewiesen sind, aus Adressen für die Quantisierungseinheiten in der ausgewählten Nachschlagetabelle zu extrahieren.

23. Vorrichtung nach Anspruch 22, wobei der Quantisierungsteil (360, 1720, 1960) einen Linearquantisierungsteil umfasst, der dazu ausgebildet ist, eine Verteilung von Abtastungen in jeder Quantisierungseinheit in eine vorgegebene Anzahl an Abschnitten zu unterteilen und die Abtastungen unter Verwendung der zugewiesenen Anzahl an Bits auf Basis einzelner Abschnitte linear zu quantisieren.

24. Vorrichtung nach Anspruch 23, wobei der Bitstromerzeugungsteil (370, 1730, 1970) einen Bitpackungsteil umfasst, der dazu ausgebildet ist, einen Bitstrom aus den linear quantisierten Abtastungen und vorgegebenen Nebeninformationen zu erzeugen.

25. Vorrichtung nach einem der Ansprüche 22 bis 24, wobei der Bitstromerzeugungsteil (370, 1730, 1970) dazu ausgebildet ist, einen aus Rahmen gebildeten Bitstrom aus den linear quantisierten Abtastungen und vorgegebenen Nebeninformationen so zu erzeugen, dass Informationen über eine Rahmenlänge am Ende des Rahmens enthalten sind.

26. Vorrichtung nach einem der Ansprüche 22 bis 25, wobei die Charakteristik des Eingabesignals beim Auswählen der Nachschlagetabelle und Erfassen der zugewiesenen Anzahl an Bits die Anzahl an Frequenzbändern ist, die Abtastungen mit Besetzungsraten von nicht weniger als oder nicht mehr als einem vorgegebenen Referenzwert unter den Frequenzbändern des Eingabesignals beinhaltet.

27. Vorrichtung nach Anspruch 26, wobei die Besetzungsrate eine höhere Besetzungsrate zwischen einer Besetzungsrate eines quadrierten Skalenfaktors eines Frequenzbands und einer Besetzungsrate eines Potenzmittelwerts von Abtastungen im Frequenzband oder eine höhere Besetzungsrate zwischen einer Besetzungsrate eines Skalenfaktors eines Frequenzbands und einer Besetzungsrate eines Mittelwerts von Abtastungen in dem Frequenzband umfasst.

28. Vorrichtung nach einem der Ansprüche 22 bis 27, wobei die Adressen jeder der Nachschlagetabellen (320, 330, 340, 1920, 1930, 1940) Skalenfaktoren oder quadrierte Skalenfaktoren der Frequenzbänder umfassen.

29. Vorrichtung nach einem der Ansprüche 22 bis 28, wobei die Adressen jeder der Nachschlagetabellen (320, 330, 340, 1920, 1930, 1940) Mittelwerte oder Potenzmittelwerte von Abtastungen in den Frequenzbändern umfassen.

**30.** Vorrichtung nach einem der Ansprüche 22 bis 29, wobei die Adressen jeder der Nachschlagetabellen (320, 330, 340, 1920, 1930, 1940) höhere Besetzungsraten zwischen Besetzungsraten von Skalenfaktoren der Frequenzbänder und Besetzungsraten von Mittelwerten von Abtastungen in den Frequenzbändern oder höhere Besetzungsraten zwischen Besetzungsraten von quadrierten Skalenfaktoren der Frequenzbänder und Besetzungsraten von Potenzmittelwerten von Abtastungen in den Frequenzbändern umfassen.

**31.** Vorrichtung nach einem der Ansprüche 22 bis 30, weiter umfassend einen Bitanzahleinstellteil, der die Anzahl an Bits, die vom Bitzuweisungsteil für das gesamte Eingabesignal zugewiesen ist, mit der erforderlichen Anzahl an Bits für das gesamte digitale Eingabesignal vergleicht und die zugewiesene Anzahl an Bits für das gesamte Eingabesignal gemäß einem Vergleichsergebnis einstellt.

**32.** Vorrichtung nach einem der Ansprüche 23 bis 31, wenn von Anspruch 23 abhängig, wobei der Linearquantisierungsteil umfasst:

einen Datennormalisierungsteil (400), der dazu ausgebildet ist, die vom Datentransformationsteil erhaltenen Abtastungen unter Verwendung eines vorgegebenen Skalenfaktors zu normalisieren,
einen Abschnittquantisierungsteil (420), der dazu ausgebildet ist, einen Bereich von normalisierten Abtastwerten in eine vorgegebene Anzahl an Abschnitten zu unterteilen und eine lineare Funktion, die für jeden Abschnitt gesetzt ist, auf die normalisierten Abtastwerte anzuwenden,
einen Skalierungsteil (440), der dazu ausgebildet ist, die vom Abschnittquantisierungsteil erhaltenen Werte unter Verwendung der für jede Quantisierungseinheit vom Bitzuweisungsteil zugewiesenen Anzahl an Bits zu skalieren, und
einen Rundungsteil (460), der dazu ausgebildet ist, die skalierten Werte unter Verwendung der Anzahl an zugewiesenen Bits auf die nächstgelegene ganze Zahl zu runden, um quantisierte Werte zu erhalten.

**33.** Vorrichtung nach Anspruch 32, wobei die linearen Funktionen eine Mehrzahl von unabhängigen linearen Funktionen für die Abschnitte umfassen.

**34.** Vorrichtung nach einem der Ansprüche 25 bis 33, wenn von Anspruch 25 abhängig, wobei der aus Rahmen gebildete Bitstrom weiter Synchronisationsinformationen beinhaltet, die einen Beginn jedes Rahmens angeben, die in einem Kopfteil jedes Rahmens gelegen sind.

**35.** Computerprogramm umfassend Computerprogrammkodemittel, die dazu ausgebildet sind, alle Schritte von einem der Ansprüche 1 bis 21 auszuführen, wenn das Programm auf einem Computer läuft.

**36.** Computerprogramm nach Anspruch 35, das auf einem computerlesbaren Medium verkörpert ist.

**Revendications**

**1.** Procédé de codage d'un signal audio numérique, comprenant :

la transformation (500) d'un signal d'entrée numérique en échantillons de telle sorte que les informations redondantes entre les signaux puissent être supprimées ;
l'obtention (520, 540) d'un nombre de bits à affecter à chacune d'une pluralité d'unités de quantification ;
la quantification (560) des échantillons en utilisant le nombre de bits affecté à chaque unité de quantification ; et
la production (580) d'un train de bits comprenant les échantillons quantifiés et des informations collatérales prédéterminées ; **caractérisé en ce que** l'obtention d'un nombre de bits à affecter comprend la sélection (520) d'une table de recherche correspondant à une caractéristique du signal d'entrée numérique parmi une pluralité de tables de recherche qui indiquent différents nombres de bits affectés à chacune d'une pluralité d'unités de quantification en fonction des caractéristiques différentes des signaux d'entrée et l'acquisition (540) du nombre de bits affecté à chaque unité de quantification à partir de la table de recherche sélectionnée.

**2.** Procédé selon la revendication 1, dans lequel la quantification des échantillons en utilisant le nombre de bits affecté à chaque unité de quantification comprend la division d'une distribution d'échantillons à l'intérieur de chaque unité de quantification en un nombre prédéterminé de sections et la quantification linéaire (560) des échantillons en utilisant le nombre de bits affecté sur une base section par section.

**3.** Procédé selon la revendication 2, dans lequel la production d'un train de bits comprend la production d'un train de bits à partir des échantillons quantifiés linéairement et des informations collatérales prédéterminées.

**4.** Procédé selon l'une quelconque des revendications précédentes, dans lequel la production d'un train de bits à partir des échantillons quantifiés et des informations collatérales prédéterminées est telle que les informations sur une longueur de trame sont enregistrées dans l'extrémité de la trame.

**5.** Procédé selon l'une quelconque des revendications précédentes, dans lequel la transformation du signal numérique est réalisée en utilisant soit une transformation en cosinus discrète modifiée, soit une transformation de Fourier rapide, soit une transformation en cosinus discrète, soit un filtrage de sous-bandes.

**6.** Procédé selon l'une quelconque des revendications précédentes, dans lequel les informations collatérales comprennent au moins un facteur d'échelle de chaque unité de quantification et un nombre de bits à affecter à chaque unité de quantification.

**7.** Procédé selon l'une quelconque des revendications 1 à 6, dans lequel la caractéristique du signal d'entrée numérique dans la sélection de la table de recherche et l'acquisition du nombre de bits affectés est le nombre de bandes de fréquence comprenant des échantillons à des taux d'occupation ni inférieurs ni supérieurs à une valeur de référence prédéterminée parmi les bandes de fréquence du signal d'entrée numérique.

**8.** Procédé selon la revendication 7, dans lequel le taux d'occupation comprend l'un d'un plus grand taux d'occupation entre un taux d'occupation du carré du facteur d'échelle d'une bande de fréquence et un taux d'occupation d'une puissance moyenne d'échantillons dans la bande de fréquence et un plus grand taux d'occupation entre un taux d'occupation d'un facteur d'échelle d'une bande de fréquence et un taux d'occupation d'une valeur moyenne d'échantillons dans la bande de fréquence.

**9.** Procédé selon l'une quelconque des revendications 1 à 8, dans lequel chacune des tables de recherche comprend au moins une adresse pour chaque unité de quantification et un nombre de bits prédéterminé pour chaque unité de quantification.

**10.** Procédé selon la revendication 9, dans lequel les adresses de chacune des tables de recherche comprennent l'un de facteurs d'échelle et de carrés de facteurs d'échelle des bandes dé fréquence.

**11.** Procédé selon la revendication 9 ou 10, dans lequel les adresses de chacune des tables de recherche comprennent l'une de valeurs moyennes et de puissances moyennes d'échantillons dans les bandes de fréquence.

**12.** Procédé selon la revendication 9, 10 ou 11, dans lequel les adresses de chacune des tables de recherche comprennent l'un de plus grands taux d'occupation entre des taux d'occupation de facteurs d'échelle des bandes de fréquence et de taux d'occupation de valeurs moyennes d'échantillons dans les bandes de fréquence, et de plus grands taux d'occupation entre les taux d'occupation de carrés de facteurs d'échelle des bandes de fréquence et des taux d'occupation de puissances moyennes d'échantillons dans les bandes de fréquence.

**13.** Procédé selon l'une quelconque des revendications 1 à 12, comprenant en outre, après la sélection de la table de recherche et l'acquisition du nombre de bits affecté, la comparaison du nombre de bits affecté à tout le signal d'entrée numérique avec le nombre de bits requis pour tout le signal d'entrée numérique et l'ajustement du nombre de bits affecté à tout le signal d'entrée numérique selon un résultat de la comparaison.

**14.** Procédé selon l'une quelconque des revendications 2 à 13 lorsqu'elle dépend de la revendication 2, dans lequel la division de la distribution des échantillons et la quantification linéaire des échantillons comprennent :

la normalisation des échantillons à l'intérieur de chaque unité de quantification et l'utilisation d'un facteur d'échelle prédéterminé ;
la division d'une gamme de valeurs échantillons normalisées en un nombre prédéterminé de sections et la transformation des valeurs échantillons normalisées par application d'un ensemble de fonctions linéaires pour chaque section ;
la mise à l'échelle des valeurs transformées en utilisant le nombre de bits affecté à chaque unité de quantification ; et
l'arrondissement des valeurs mises à l'échelle au nombre entier le plus proche pour obtenir des valeurs quantifiées.

**15.** Procédé selon la revendication 14, dans lequel le facteur d'échelle est un nombre entier déterminé par une fonction prédéterminée d'une valeur qui n'est pas inférieure à une valeur absolue maximum parmi les valeurs échantillons dans chaque unité de quantification.

**16.** Procédé selon la revendication 14 ou 15, dans lequel les fonctions linéaires comprennent une pluralité de fonctions linéaires indépendantes pour les sections.

**17.** Procédé selon la revendication 16, dans lequel la division de la gamme de valeurs échantillons normalisées et la transformation des valeurs échantillons normalisées comprennent :

la division de la gamme de valeurs échantillons normalisées en deux sections ; et
la transformation des données normalisées en appliquant aux données normalisées des fonctions linéaires définies pour les deux sections,

dans lequel les fonctions linéaires sont exprimées par

$$y = \frac{ax}{(a - 2b)} \quad \text{et} \quad y = \frac{x}{(1 + 2b)} + \frac{2b}{(1 + 2b)}$$

où a dénote la gamme de valeurs normalisées, et b dénote le déplacement des sections par rapport au centre de a.

**18.** Procédé selon l'une quelconque des revendications 14 à 17, dans lequel la quantification linéaire par sections satisfait la continuité.

**19.** Procédé selon l'une quelconque des revendications 4 à 18 lorsqu'elle dépend de la revendication 4, dans lequel le train de bits constitué de trames comprend en outre des informations de synchronisation indiquant le commencement de chaque trame, qui est situé dans la partie avant de chaque trame.

**20.** Procédé selon la revendication 19, dans lequel le train de bits constitué de trames est le résultat du codage à un débit binaire fixe ou à un débit binaire variable.

**21.** Procédé selon l'une quelconque des revendications 4 à 20, lorsqu'elle dépend de la revendication 4, dans lequel le train de bits constitué de trames est le résultat du codage à un débit binaire fixe ou à un débit binaire variable.

**22.** Appareil pour coder un signal audio numérique, comprenant :

une partie de transformation de données (300, 1700, 1900), agencée pour transformer un signal d'entrée numérique en échantillons de telle sorte que des informations redondantes entre les signaux puissent être supprimées ;
une partie d'obtention de nombre de bits à affecter (310, 320, 330, 340, 350) comprenant une table de recherche (320, 1920) agencée pour obtenir le nombre de bits à affecter à chacune d'une pluralité d'unité de quantification ;
une partie de quantification (360, 1720, 1960) pour quantifier les échantillons en utilisant le nombre de bits affecté à chaque unité de quantification par la partie d'obtention de nombre de bits à affecter ; et
une partie de production de train de bits (370, 1730, 1970) agencée pour produire un train de bits comprenant les échantillons quantifiés et les informations collatérales prédéterminées ;

**caractérisé en ce que** la partie d'obtention de nombre de bits à affecter comprend :

une pluralité de tables de recherche (320, 330, 340) agencée pour indiquer différents nombres de bits affectés à chacune d'une pluralité d'unités de quantification dépendant de différentes caractéristiques de signaux d'entrée ;
une partie de sélection de table de recherche (310, 1910) agencée pour sélectionner une table de recherche correspondant à une caractéristique du signal d'entrée numérique parmi les tables de recherche ; et

une partie d'affectation de bits (350, 1950) agencée pour extraire les nombres de bits affectés aux unités de quantification d'adresses des unités de quantification dans la table de recherche sélectionnée.

23. Appareil selon la revendication 22, dans lequel la partie de quantification (360, 1720, 1960) comprend une partie de quantification linéaire agencée pour diviser une distribution d'échantillon dans chaque unité de quantification en un nombre prédéterminé de sections et pour quantifier linéairement les échantillons en utilisant le nombre de bits affecté sur une base section par section.

24. Appareil selon la revendication 23, dans lequel la partie de production de trains de bits (370, 1730, 1970) comprend une partie de compression de bits agencée pour produire un train de bits à partir des échantillons quantifiés linéairement et des informations collatérales prédéterminées.

25. Appareil selon l'une quelconque des revendications 22 à 24, dans lequel la partie de production de trains de bits (370, 1730, 1970) est agencée pour produire un train de bits constitué de trames à partir des échantillons quantifiés linéairement et des informations collatérales prédéterminées de telle sorte que les informations sur une longueur de trame sont incluses dans l'extrémité de la trame.

26. Appareil selon l'une quelconque des revendications 22 à 25, dans lequel la caractéristique du signal d'entrée dans la sélection de la table de recherche et l'acquisition du nombre de bits affecté est le nombre de bandes de fréquence comprenant des échantillons à des taux d'occupation qui ne sont ni inférieurs ni supérieurs à une valeur de référence prédéterminée parmi les bandes de fréquence du signal d'entrée.

27. Appareil selon la revendication 26, dans lequel le taux d'occupation est l'un d'un plus grand taux d'occupation entre un taux d'occupation du carré du facteur d'échelle d'une bande de fréquence et un taux d'occupation d'une puissance moyenne d'échantillons dans la bande de fréquence et un plus grand taux d'occupation entre un taux d'occupation d'un facteur d'échelle d'une bande de fréquence et un taux d'occupation d'une valeur moyenne d'échantillons dans la bande de fréquence.

28. Appareil selon l'une quelconque des revendications 22 à 27, dans lequel les adresses de chacune des tables de recherche (320, 330, 340, 1920, 1930, 1940) sont soit des facteurs d'échelle soit des carrés de facteurs d'échelle des bandes de fréquence.

29. Appareil selon l'une quelconque des revendications 22 à 28, dans lequel les adresses de chacune des tables de recherche (320, 330, 340, 1920, 1930, 1940) sont soit des valeurs moyennes soit des puissances moyennes d'échantillons dans les bandes de fréquence.

30. Appareil selon l'une quelconque des revendications 22 à 29, dans lequel les adresses de chacune des tables de recherche (320, 330, 340, 1920, 1930, 1940) sont l'un de plus grands taux d'occupation entre des taux d'occupation de facteurs d'échelle des bandes de fréquence et de taux d'occupation de valeurs moyennes échantillons dans les bandes de fréquence, et de plus grands taux d'occupation entre les taux d'occupation de carrés de facteurs d'échelle des bandes de fréquence et des taux d'occupation de puissances moyennes d'échantillons dans les bandes de fréquence.

31. Appareil selon l'une quelconque des revendications 22 à 30, comprenant en outre une partie d'ajustement du nombre de bits comparant le nombre de bits affecté au signal d'entrée entier par la partie d'affectation de bits avec le nombre de bits requis pour le signal d'entrée entier et ajustant le nombre de bits affecté au signal d'entrée entier conformément à un résultat de la comparaison.

32. Appareil selon l'une quelconque des revendications 23 à 31, lorsqu'elle dépend de la revendication 23, dans lequel la partie de quantification linéaire comprend :

une partie de normalisation de données (400) agencée pour normaliser les échantillons obtenus par la partie de transformation de données en utilisant un facteur d'échelle prédéterminé ;
une partie de quantification de sections (420) agencée pour diviser une gamme de valeurs échantillons normalisées en un nombre de sections prédéterminé et pour appliquer un ensemble de fonctions linéaires pour chaque section aux valeurs échantillons normalisées ;
une partie de mise à l'échelle (440) agencée pour mettre à l'échelle les valeurs obtenues par la partie de quantification de sections en utilisant le nombre de bits affecté à chaque unité de quantification par la partie d'affectation de bits ; et
une partie d'arrondissement (460) agencée pour arrondir les valeurs mises à l'échelle au nombre entier le plus proche en utilisant le nombre de bits affecté pour obtenir les valeurs quantifiées.

33. Appareil selon la revendication 32, dans lequel les fonctions linéaires sont une pluralité de fonctions linéaires indépendantes pour les sections.

34. Appareil selon l'une quelconque des revendications 25 à 33, lorsqu'elle dépend de la revendication 25, dans lequel le train de bits constitué de trames comprend en outre des informations de synchronisation indiquant un commencement de chaque trame, qui est situé dans une partie avant de chaque trame.

35. Programme d'ordinateur comprenant un moyen de code de programme d'ordinateur adapté pour exécuter toutes les étapes de l'une quelconque des revendications 1 à 21 lorsque ledit programme est exécuté sur un ordinateur.

36. Programme d'ordinateur selon la revendication 35, incorporé sur un support lisible par un ordinateur.

## FIG. 1 (PRIOR ART)

```
   100           120            130            140
┌──────────┐  ┌──────────┐  ┌──────────┐  ┌──────────┐
│FREQUENCY │  │   BIT    │  │QUANTIZATION│  │BITSTREAM │
│ MAPPING  │─▶│ALLOCATION│─▶│ PORTION  │─▶│PRODUCING │─▶
│ PORTION  │  │ PORTION  │  │          │  │ PORTION  │
└──────────┘  └──────────┘  └──────────┘  └──────────┘
                   ▲
   110             │
┌──────────┐       │
│ PSYCHO-  │       │
│ ACOUSTIC │───────┘
│  MODEL   │
└──────────┘
```

## FIG. 2 (PRIOR ART)

```
   200             220            230            240
┌──────────┐  ┌────────────┐  ┌──────────┐  ┌──────────┐
│FREQUENCY │  │ NUMBER-OF- │  │QUANTIZATION│  │BITSTREAM │
│ MAPPING  │─▶│ALLOCATED-BITS│─▶│ PORTION  │─▶│PRODUCING │─▶
│ PORTION  │  │ EXTRACTION │  │          │  │ PORTION  │
└──────────┘  │  PORTION   │  └──────────┘  └──────────┘
              └────────────┘
                    ▲
                    │
              ┌──────────┐
              │  LOOKUP  │
              │  TABLE   │── 210
              └──────────┘
```

## FIG. 3

DIGITAL SIGNAL → DATA TRANSFORMATION PORTION (300) → LINEAR QUANTIZATION PORTION (360) → BIT PACKING PORTION (370) → BITSTREAM

BIT ALLOCATION PORTION (350)

LOOKUP TABLE SELECTION PORTION (310)

FIRST LOOKUP TABLE (320)    SECOND LOOKUP TABLE (330)   · · ·   n-TH LOOKUP TABLE (340)

EP 1 600 946 B1

# FIG. 4

360

| 400 | 420 | 440 | 460 |
|---|---|---|---|
| DATA NORMALIZATION PORTION | SECTION QUANTIZATION PORTION | SCALING PORTION | ROUNDING PORTION |

# FIG. 5

```
START
  ↓
TRANSFORMS INPUT DIGITAL        ── 500
SIGNAL INTO SAMPLE DATA
  ↓
SELECT LOOKUP TABLE
ACCORDING TO CHARACTERISTICS    ── 520
OF INPUT DIGITAL SIGNAL
  ↓
ALLOCATE NUMBERS OF BITS FOR    ── 540
EACH QUANTIZATION UNIT
  ↓
LINEARLY QUANTIZE SAMPLE        ── 560
DATA BY SECTIONS
  ↓
PERFORM BITPACKING             ── 580
  ↓
END
```

# FIG. 6

520

```
┌─────────────────┐
│      START      │
└─────────────────┘
         │
         ▼
┌──────────────────────────────────┐
│   CALCULATE SCALE FACTOR OF EACH │
│   FREQUENCY BAND AND MEAN POWER OF│─── 600
│   INPUT SIGNALS IN EACH FREQUENCY BAND│
└──────────────────────────────────┘
         │
         ▼
┌──────────────────────────────────┐
│  CALCULATE OCCUPANCY RATE OF SQUARED│
│  SCALE FACTOR OF EACH FREQUENCY BAND│
│  AND OCCUPANCY RATE OF MEAN POWER OF│─── 610
│  INPUT SIGNALS IN EACH FREQUENCY BAND│
└──────────────────────────────────┘
         │
         ▼
┌──────────────────────────────────┐
│   SELECT A LARGER VALUE BETWEEN THE│
│   TWO CALCULATED OCCUPANCY RATES AS│─── 620
│  OCCUPANCY RATE OF EACH FREQUENCY BAND│
└──────────────────────────────────┘
         │
         ▼
┌──────────────────────────────────┐
│  CALCULATE NUMBER OF FREQUENCY BANDS│
│  (LP) WHOSE OCCUPANCY RATES ARE LOWER│
│  THAN OR EQUAL TO REFERENCE OCCUPANCY│─── 630
│  (HP) WHOSE OCCUPANCY RATES ARE     │
│  EQUAL TO OR HIGHER THAN REFERENCE  │
│  OCCUPANCY RATE                     │
└──────────────────────────────────┘
         │
         ▼
┌──────────────────────────────────┐
│   SELECT ONE OF PLURALITY OF LOOKUP│─── 640
│   TABLES ACCORDING TO LP OR HP     │
└──────────────────────────────────┘
         │
         ▼
┌─────────────────┐
│       END       │
└─────────────────┘
```

## FIG. 7A

## FIG. 7B

# FIG. 8

```
               ┌─────────────────────┐
               │   POERATION 540     │
               └─────────────────────┘
                          │
                          ▼
        ┌──────────────────────────────────┐
        │  CALCULATE NUMBER OF BITS         │
        │  ACTUALLY ALLOCATED TO        ─── 810
        │  THE ENTIRE INPUT SIGNAL          │
        └──────────────────────────────────┘
                          │
                          ▼
                IS NUMBER OF
        BITS ACTUALLY ALLOCATED TO THE
  YES   ENTIRE INPUT SIGNAL EQUAL TO NUMBER OF  ─── 820
        BITS REQUIRED TO BE ALLOCATED
             FOR THE ENTIRE INPUT
                   SIGNAL ?
                          │
                         NO
                          │        830
                          ▼
                 IS NUMBER OF
               ACTUALLY ALLOCATED BITS
             GREATER THAN NUMBER OF BITS       NO
                REQUIRED TO BE
                  ALLOCATED ?
                          │
                        YES
         840                              850
          │                                │
          ▼                                ▼
┌──────────────────────────┐    ┌──────────────────────────┐
│ DECREASE NUMBER OF BITS   │    │ INCREASE NUMBER OF ACTUALLY│
│ ACTUALLY ALLOCATED FOR EACH│   │ ALLOCATED BITS FOR EACH   │
│ FREQUENCY BAND BY ONE UNTIL│   │ FREQUENCY BAND BY ONE UNTIL│
│ BEING EQUAL TO NUMBER OF   │   │ BEING EQUAL TO NUMBER OF   │
│ BITS REQUIRED TO BE ALLOCATED│ │ BITS REQUIRED TO BE ALLOCATED│
└──────────────────────────┘    └──────────────────────────┘
                          │
                          ▼
               ┌─────────────────────┐
               │   POERATION 560     │
               └─────────────────────┘
```

# FIG. 9

560

| NORMALIZE SAMPLE DATA | — 900 |

| APPLY LINEAR FUNCTIONS SET BY SECTIONS TO SAMPLE DATA | — 920 |

| SCALE MAPPED SAMPLE DATA USING THE NUMBER OF ALLOCATED BITS | — 940 |

| ROUND THE SCALED SAMPLE DATA | — 960 |

# FIG. 10

# FIG. 11

EP 1 600 946 B1

# FIG. 12

## FIG. 13

FIG. 14

t-TH FRAME | (t-1)TH FRAME

FRAME LENGTH INFORMATION 1420

ENCODED DATA 1410

FRAME LENGTH INFORMATION 1420

ENCODED DATA 1410

FIG. 15

t-TH FRAME | (t-1)TH FRAME

FRAME LENGTH INFORMATION 1530

ENCODED DATA 1520

SYNC INFORMATION 1510

FRAME LENGTH INFORMATION 1530

ENCODED DATA 1520

SYNC INFORMATION 1510

# FIG. 16

```
                    ┌─────────────┐
                    │    START    │
                    └──────┬──────┘
                           ↓
        ┌──────────────────────────────────┐
        │ TRANSFORMS INPUT DIGITAL SIGNAL   │──1600
        │        INTO SAMPLE DATA           │
        └──────────────────┬───────────────┘
                           ↓
        ┌──────────────────────────────────┐
        │       SELECT LOOKUP TABLE         │
        │ ACCORDING TO CHARACTERISTICS      │──1620
        │      OF INPUT DIGITAL SIGNAL      │
        └──────────────────┬───────────────┘
                           ↓
        ┌──────────────────────────────────┐
        │  ALLOCATE NUMBERS OF BITS FOR     │──1640
        │     EACH QUANTIZATION UNIT        │
        └──────────────────┬───────────────┘
                           ↓
        ┌──────────────────────────────────┐
        │       QUANTIZE SAMPLE DATA        │──1660
        └──────────────────┬───────────────┘
                           ↓
        ┌──────────────────────────────────┐
        │      PRODUCE BITSTREAM            │──1680
        │    COMPRISED OF FRAMES            │
        └──────────────────┬───────────────┘
                           ↓
                    ┌─────────────┐
                    │     END     │
                    └─────────────┘
```

# FIG. 17

```
           1700              1720              1730
                                                         
DIGITAL      DATA           LINEAR          BITSTREAM
SIGNAL → TRANSFORMATION → QUANTIZATION → PRODUCING  → BITSTREAM
            PORTION         PORTION         PORTION

                        NUMBER-OF-BITS
                        -TO-BE-ALLOCATED
                          CALCULATION  — 1710
                            PORTION
```

# FIG. 18

```
                    ┌─────────────┐
                    │    START    │
                    └──────┬──────┘
                           │
          ┌────────────────────────────────┐
          │   TRANSFORMS INPUT DIGITAL      │—1800
          │     SIGNAL INTO SAMPLE DATA     │
          └────────────────┬───────────────┘
                           │
          ┌────────────────────────────────┐
          │   CALCULATE THE NUMBER OF       │
          │ BITS TO BE ALLOCATED FOR EACH   │—1820
          │      QUANTIZATION UNIT          │
          └────────────────┬───────────────┘
                           │
          ┌────────────────────────────────┐
          │  PERFORM LINEAR QUANTIZATION    │—1840
          │          BY SECTIONS            │
          └────────────────┬───────────────┘
                           │
          ┌────────────────────────────────┐
          │  PRODUCE BITSTREAM COMPRISED    │—1860
          │          OF FRAMES              │
          └────────────────┬───────────────┘
                           │
                    ┌─────────────┐
                    │     END     │
                    └─────────────┘
```

# FIG. 19

EP 1 600 946 B1

# FIG. 20

```
                  ┌──────────────┐
                  │    SRTAT     │
                  └──────┬───────┘
                         │
         ┌───────────────▼───────────────┐
         │   TRANSFORMS INPUT DIGITAL     │──2000
         │   SIGNAL INTO SAMPLE DATA      │
         └───────────────┬───────────────┘
                         │
         ┌───────────────▼───────────────┐
         │     SELECT LOOKUP TABLE        │
         │ ACCORDING TO CHARACTERISTICS   │──2020
         │   OF INPUT DIGITAL SIGNAL      │
         └───────────────┬───────────────┘
                         │
         ┌───────────────▼───────────────┐
         │  ALLOCATE NUMBERS OF BITS FOR  │──2040
         │    EACH QUANTIZATION UNIT      │
         └───────────────┬───────────────┘
                         │
         ┌───────────────▼───────────────┐
         │   LINEARLY QUANTIZE SAMPLE     │──2060
         │      DATA BY SECTIONS          │
         └───────────────┬───────────────┘
                         │
         ┌───────────────▼───────────────┐
         │     PRODUCE BITSTREAM          │──2080
         │    COMPRISED OF FRAMES         │
         └───────────────┬───────────────┘
                         │
                  ┌──────▼───────┐
                  │     END      │
                  └──────────────┘
```

# FIG. 21

START

INCLUDE INPUT SIGNALS HAVING VARIOUS CHARACTERISTICS CLASSIFIED INTO GROUPS OF INPUT SIGNALS HAVING IDENTICAL CHARACTERISTICS — 2100

DIVIDE ONE OF INPUT SIGNALS HAVING IDENTICAL CHARACTERISTIC BY FREQUENCY BANDS — 2110

CALCULATE THE NUMBER OF BITS TO BE ALLOCATED FOR EACH FREQUENCY BAND OF INPUT. SIGNAL USING PSYCHOACOUSTIC MODEL — 2120

CALCULATE ADDRESS VALUES FOR FREQUENCY BANDS OF INPUT SIGNAL — 2130

RECORD THE FREQUENCY OF CALCULATIONS OF THE NUMBER OF BITS CALCULATED IN OPERATION 2120 — 2140

HAVE ALL OF INPUT SIGNALS HAVING IDENTICAL CHARACTERISTIC UNDERGONE OPERATIONS 2110 THROUGH 2140 ? — 2150

NO

YES

STORE NUMBER OF BITS THAT IS THE MOST FREQUENTLY CALCULATED AMONG THE NUMBERS OF BITS STORED IN EACH OF THE ADDRESSES FOR THE FREQUENCY BANDS, AS THE NUMBER OF BITS TO BE ALLOCATED FOR EACH FREQUENCY BAND TO PRODUCE LOOKUP TABLE — 2160

HAVE LOOKUP TABLES FOR ALL CHARACTERISTICS OF INPUT SIGNALS BEEN PRODUCED ? 2170

NO

YES

END

# FIG. 22

START

INCLUDE PREDETERMINED NUMBER OF INPUT SIGNALS — 2200

CLASSIFY INPUT SIGNALS ACCORDING TO CHARACTERISTICS OF INPUT SIGNALS — 2210

DIVIDE ONE OF INPUT SIGNALS HAVING IDENTICAL CHARACTERISTIC BY FREQUENCY BANDS — 2220

CALCULATE THE NUMBER OF BITS TO BE ALLOCATED FOR EACH FREQUENCY BAND OF INPUT SIGNAL USING PSYCHOACOUSTIC MODEL — 2230

CALCULATE ADDRESS VALUES FOR FREQUENCY BANDS OF INPUT SIGNAL — 2240

RECORD THE FREQUENCY OF CALCULATIONS OF THE NUMBER OF BITS CALCULATED IN OPERATION 2230 — 2250

HAVE ALL OF INPUT SIGNALS HAVING IDENTICAL CHARACTERISTIC UNDERGONE OPERATIONS 2220 THROUGH 2250 ? — 2260

NO

YES

STORE NUMBER OF BITS THAT IS THE MOST FREQUENTLY CALCULATED AMONG THE NUMBERS OF BITS STORED IN EACH OF THE ADDRESSES FOR THE FREQUENCY BANDS, AS THE NUMBER OF BITS TO BE ALLOCATED FOR EACH FREQUENCY BAND TO PRODUCE LOOKUP TABLE — 2270

HAVE LOOKUP TABLES FOR ALL CHARACTERISTICS OF INPUT SIGNALS BEEN PRODUCED ? — 2280

NO

YES

END

## FIG. 23

| ADDRESS | 0 | 1 | 2 | 3 | 4 | | 127 |
|---|---|---|---|---|---|---|---|
| SR | 1.0000000 | 0.8404964 | 0.7071068 | 0.5946036 | 0.5000000 | | 0.0000000 |

## FIG. 24

| NUMBER OF BITS TO BE ALLOCATED / ADDRESS | 0 | 1 | · · · | 7 | 8 | · · · | 14 | 15 |
|---|---|---|---|---|---|---|---|---|
| · · · | | | | | | | | |
| 5 | 2 | 3 | · · · | 1300 | 6543 | · · · | 189 | 89 |
| · · · | | | | | | | | |
| 30 | 5 | 3 | · · · | 5656 | 787 | · · · | 547 | 54 |
| 31 | | | | | | | | |
| · · · | | | | | | | | |
| 61 | 7890 | 2356 | · · · | 56 | 3 | · · · | 0 | 0 |

# FIG. 25

2500

2520

2540

BITSTREAM → | BITSTREAM UNPACKING PORTION | → | LINEAR DEQUANTIZATION PORTION | → | INVERSE TRANSFORMATION PORTION | → DIGITAL SIGNAL

# FIG. 26

2520

2600

2610

2620

→ | INVERSE SCALING PORTION | → | SECTION LINEAR DEQUANTIZATION PORTION | → | DENORMALIZATION SCALING | →

EP 1 600 946 B1

# FIG. 27

```
        ┌─────────────┐
        │    START    │
        └─────────────┘
               │
               ▼
┌───────────────────────────────┐
│  EXTRACT LINEAR QUANTIZED SAMPLE │
│  DATA AND SIDE INFORMATION      │──── 2700
│  FROM AUDIO BITSTREAM           │
└───────────────────────────────┘
               │
               ▼
┌───────────────────────────────┐
│  DEQUANTIZE LINEAR QUANTIZED SAMPLE │
│  DATA USING SIDE INFORMATION    │──── 2720
└───────────────────────────────┘
               │
               ▼
┌───────────────────────────────┐
│  INVERSELY TRANSFORM DEQUANTIZED │
│  DATA INTO DIGITAL SIGNAL       │──── 2740
└───────────────────────────────┘
               │
               ▼
        ┌─────────────┐
        │     END     │
        └─────────────┘
```

# FIG. 28

2720

```
               │
               ▼
┌───────────────────────────────┐
│  INVERSELY SCALE LINEAR QUANTIZED │
│  SAMPLE DATA USING ALLOCATION   │──── 2800
│  INFORMATION                    │
└───────────────────────────────┘
               │
               ▼
┌───────────────────────────────┐
│  LINEARLY DEQUANTIZE INVERSELY-SCALED │
│  DATA IN EACH SECTION           │──── 2820
└───────────────────────────────┘
               │
               ▼
┌───────────────────────────────┐
│  DENORMALIZE DEQUANTIZED DATA   │──── 2840
└───────────────────────────────┘
               │
               ▼
```

# FIG. 29

2900

BITSTREAM
ANALYZING
PORTION

2920

DEQUANTIZATION
PORTION

2940

INVERSE
TRANFORMATION
PORTION

# FIG. 30

2900

3000

SYNC
INFORMATION
ANALYZING
PORTION

3020

SIDE
INFORMATION
ANALYZING
PORTION

3040

QUANTIZED
DATA
ANALYZING
PORTION

3060

FRAME LENGTH
INFORMATION
ANALYZING
PORTION

# FIG. 31

```
           START
             |
             v
┌─────────────────────────────┐
│  EXTRACT QUANTIZED SAMPLED DATA, │
│  SIDE INFORMATION, AND FRAME     │──── 3100
│  LENGTH INFORMATION FROM         │
│  AUDIO BITSTREAM                 │
└─────────────────────────────┘
             |
             v
┌─────────────────────────────┐
│  DEQUANTIZE QUANTIZED SAMPLE DATA │──── 3120
│  USING SIDE INFORMATION          │
└─────────────────────────────┘
             |
             v
┌─────────────────────────────┐
│  INVERSELY TRANSFORM DEQUANTIZED │──── 3140
│  DATA INTO DIGITAL SIGNAL        │
└─────────────────────────────┘
             |
             v
            END
```

# FIG. 32

```
        3200              3220                 3240
         |                 |                    |
┌──────────────┐  ┌──────────────────┐  ┌──────────────────┐
│  BITSTREAM   │  │     LINEAR       │  │    INVERSE       │
│  ANALYZING   │─▶│  DEQUANTIZATION  │─▶│  TRANFORMATION   │─▶
│  PORTION     │  │    PORTION       │  │    PORTION       │
└──────────────┘  └──────────────────┘  └──────────────────┘
```

# FIG. 33

```
┌─────────────┐
│    START    │
└─────────────┘
       │
       ▼
┌──────────────────────────────┐
│  EXTRACT QUANTIZED SAMPLED    │
│  DATA, SIDE INFORMATION, AND  │ ── 3300
│  FRAME LENGTH INFORMATION     │
│  FROM AUDIO BITSTREAM         │
└──────────────────────────────┘
       │
       ▼
┌──────────────────────────────┐
│  DEQUANTIZE LINEAR QUANTIZED  │
│  SAMPLE DATA USING SIDE       │ ── 3320
│  INFORMATION                  │
└──────────────────────────────┘
       │
       ▼
┌──────────────────────────────┐
│  INVERSELY TRANSFORM          │
│  DEQUANTIZED DATA INTO        │ ── 3340
│  DIGITAL SIGNAL               │
└──────────────────────────────┘
       │
       ▼
┌─────────────┐
│     END     │
└─────────────┘
```

**EP 1 600 946 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5864802 A

- EP 1596366 A